# EUROPÄISCHE PATENTSCHRIFT

(11) **EP 3 367 419 B1**
(45) Veröffentlichungstag und Bekanntmachung des Hinweises auf die Patenterteilung: **14.08.2019**
(21) Anmeldenummer: 17158448.5
(22) Anmeldetag: 28.02.2017
(51) Int. Cl.: H01J 37/32

(54) **ELEKTRODENEINHEIT MIT EINEM INTERNEN ELEKTRISCHEN NETZWERK ZUR ZUFÜHRUNG VON HOCHFREQUENTER SPANNUNG UND TRÄGERANORDNUNG FÜR EINE PLASMABEHANDLUNGSANLAGE**
ELECTRODE UNIT WITH AN INTERNAL ELECTRIC NETWORK FOR FEEDING HIGH FREQUENCY VOLTAGE AND CARRIER ASSEMBLY FOR A PLASMA PROCESSING SYSTEM
UNITÉ D'ÉLECTRODE COMPRENANT UN RÉSEAU ÉLECTRIQUE INTERNE DESTINÉ À TRANSPORTER LA TENSION HAUTE FRÉQUENCE ET SYSTÈME DE SUPPORT POUR UNE INSTALLATION DE TRAITEMENT AU PLASMA

(43) Veröffentlichungstag der Anmeldung: 29.08.2018
(73) Patentinhaber: Meyer Burger (Germany) AG, 09337 Hohenstein-Ernstthal (DE)
(72) Erfinder: Schlemm, Hermann, 07751 Milda (DE); Kehr, Mirko, 09439 Amtsberg (DE); Ansorge, Erik, 09127 Chemnitz (DE)
(74) Vertreter: Kailuweit & Uhlemann Patentanwälte Partnerschaft mbB

(56) Entgegenhaltungen:
- EP-A1- 2 299 479
- WO-A1-2013/046286
- JP-A- 2003 031 504

## Beschreibung

Die Erfindung betrifft eine Elektrodeneinheit für eine Plasmabehandlungsanlage, wobei die Elektrodeneinheit eine Mehrzahl von Plasmaelektrodenpaaren, die zum Erzeugen eines kapazitiv gekoppelten Plasmas, insbesondere im Vakuum, geeignet sind, enthält, und den beiden Plasmaelektroden jedes Plasmaelektrodenpaares eine unterschiedliche elektrische hochfrequente Spannung jeweils über ein internes elektrisches Zuführungsnetzwerk zugeführt wird. Des Weiteren betrifft die Erfindung auch eine Trägeranordnung für eine Plasmabehandlungsanlage, wobei die Trägeranordnung mindestens zwei derartige Elektrodeneinheiten enthält.

Plasmaprozesse werden beispielsweise in der Solarzellenherstellung, der Mikroelektronik oder der Veredlung von Substratoberflächen (z. B. Glas) zur Abscheidung oder Entfernung von Schichten oder Partikeln, zur Dotierung von Schichten, zum Beispiel durch Plasmaimmersionslonenimplantation, oder zum Reinigen oder Aktivieren der Oberfläche eines Substrates genutzt. Im Folgenden werden alle diese Plasmaprozesse als Plasmabehandlung bezeichnet.

Bei kapazitiv gekoppelten Plasmen befindet sich das zu behandelnde Substrat in einem Raum zwischen zwei Plasmaelektroden, wobei an diese zwei Plasmaelektroden eine nieder- oder hochfrequente Spannung angelegt wird. Dabei wird das Substrat meist über einen direkten ohmschen Kontakt mit einer der Plasmaelektroden mit einer Spannung beaufschlagt. Jedoch können sich insbesondere bei der plasmaunterstützten Abscheidung dielektrischer Schichten auch auf der Plasmaelektrode entsprechende isolierende Schichten zumindest in einem Substratrandbereich ausbilden, die die Homogenität der Abscheidung auf weiteren, nachfolgend auf dieselbe Plasmaelektrode aufgelegten Substraten negativ beeinflussen.

Um den Durchsatz von Substraten bei der Plasmabehandlung zu erhöhen, werden batch-Systeme, in denen mehrere Substrate gleichzeitig behandelt werden, verwendet. Dabei können die Substrate mit der zu prozessierenden Oberfläche neben- oder übereinander angeordnet sein. Die Substrate sind jeweils zwischen den Plasmaelektroden eines Plasmaelektrodenpaares angeordnet, die elektrisch voneinander isoliert und so mit einer Spannungszuführung verbunden sind, dass zwischen den Plasmaelektroden jedes dieser Plasmaelektrodenpaare kapazitiv ein Plasma erzeugt werden kann. Bei übereinander angeordneten Substraten werden in einer Plasmaelektrodeneinheit bis zu 200 Plasmaelektroden, die jeweils in einem typischen Abstand von 3 mm bis 30 mm parallel zueinander angeordnet sind so miteinander elektrisch verschaltet, dass jede zweite Plasmaelektrode einen gemeinsamen elektrischen Anschluss aufweist. An die so entstandene Anordnung aus zwei Elektrodengruppen mit zwei Anschlüssen wird nun eine Wechselspannung angelegt, die ausreichend groß ist, um zwischen allen Plasmaelektroden ein Plasma zu zünden. Vorzugsweise wird hierzu eine, bezüglich der die Plasmaelektroden umgebenden Masse (Vakuumkammer und weitere Einbauten) symmetrische Spannung angelegt, d.h. wenn an die eine Elektrodengruppe eine positive Spannung +U/2 angelegt wird, so wird an die andere Elektrodengruppe -U/2 angelegt. Damit liegt nur zwischen den Plasmaelektroden die Spannung U an, die ausreichend groß zum Erzeugen des Plasmas zwischen den Plasmaelektroden ist. Zu den umgebenden Masseteilen wird kein Plasma erzeugt, weil die hier anliegende Spannung mit U/2 zu klein zur Plasmaerzeugung ist. Diese Art der Plasmaerzeugung (symmetrische Generatorankopplung) ist besonders bei Plasmaprozessen mit vielen Substraten auf vielen Plasmaelektroden vorteilhaft, weil auf die Isolation von spannungsführenden Teilen zur Vermeidung parasitärer Plasmen nahezu komplett verzichtet werden kann.

Solch eine Elektrodeneinheit ist bspw. in der EP 0 143 479 A1 beschrieben. Dabei werden die einzelnen Elektrodenplatten durch elektrisch isolierende Abstandselemente in einem definierten Abstand voneinander gehaltert und jeweils mit einem elektrischen Leiter, der an einem Träger angeordnet ist, kontaktiert. Die Elektrodeneinheit enthält somit zwei Träger mit je einem elektrischen Leiter, wobei sich die Träger jeweils über die gesamte Länge der Elektrodeneinheit, d.h. von der ersten Elektrodenplatte bis zur letzten Elektrodenplatte, erstrecken.

Die WO 2013/046286 A1 offenbart ebenfalls eine Elektrodeneinheit mit mehreren Plasmaelektrodenpaaren mit jeweils einer Kathode und einer Anode. Dabei sind alle Kathoden als abstehende Bereiche von einer gemeinsamen Verbindungskathode realisiert und alle Anoden sind als Substrathalteplatten, welche sich von einer gemeinsamen Fixierplatte erstrecken, ausgeführt. Die Elektroden und die sie elektrisch verbindenden Elemente bestehen aus Carbon, Edelstahl, Kupfer, Kupferlegierungen, Glas oder Keramik, wobei die Materialauswahl nach der Sekundärelektronenemissionsrate, dem Preis oder chemischen und thermischen Prozesseigenschaften erfolgt. Die an der Kathode angelegte Spannung kann eine Frequenz von 250 kHz bis zu 27 MHz aufweisen.

Auch die DE 10 2015 004 352 A1 beschreibt eine ähnliche Elektrodeneinheit, bei der jeder plattenförmige und elektrisch leitfähige Substratträger in einer jeweiligen Ebene angeordnet und mit einer Kontaktnase versehen ist. Zwischen zwei elektrisch gleich beschalteten Substratträgern ist jeweils ein Kontaktblock aus einem elektrisch gut leitenden Material, insbesondere Graphit, angeordnet, welcher die elektrische Verbindung zwischen den einzelnen Substratträgern und damit die Zuführung der Spannung über alle gleichbeschalteten Substratträger und gleichzeitig die Aufrechterhaltung eines vorbestimmten Abstandes zueinander gewährleistet.

Üblicherweise werden massive Graphitstäbe bzw. Kontaktstücke aus Graphit mit einem Querschnitt von (20x5) mm² zur Zuführung der Spannung an gleichbeschaltete Plasmaelektroden genutzt.

Diese Art der Spannungszuführung ist gut geeignet, eine niederfrequente Spannung mit einer Frequenz im Bereich von 10 Hz bis 1000 kHz gleichmäßig allen gleichbeschalteten Plasmaelektroden zuzuführen. Damit liegt an jeder gleichbeschalteten Plasmaelektrode dieselbe Spannung an, so dass in allen Plasmaelektrodenpaaren der Elektrodeneinheit ein homogenes Plasma erzeugt werden kann.

Während die oben erwähnte symmetrische Plasmabeschaltung für niederfrequente Spannungen von 10 Hz bis 1000 kHz Stand der Technik ist und vielfältig angewendet wird, ist dies für Hochfrequenzplasmen mit Frequenzen von 1 MHz bis 100 MHz problematisch.

Plasmaprozesse mit Spannungen mit höheren Frequenzen, bspw. 13,56 MHz oder 40 MHz, haben besondere Vorteile, wie bspw. eine gute Homogenität der Substratbehandlung auch bei dicken parasitären dielektrischen Schichten auf den Plasmaelektroden im Substratrandbereich und eine schonende Substratbehandlung durch eine niedrige Energie der auf dem Substrat aus dem Plasma auftreffenden Ionen. Solche Hochfrequenzplasmen und die dazugehörigen Plasmaprozesse (wie z.B. Plasma Enhanced Chemical Vapour Deposition (PECVD) oder Reactive Ion Etching (RIE)) haben in der Halbleiterindustrie Niederfrequenzplasmaprozesse aufgrund ihrer oben erwähnten Prozessvorteile komplett verdrängt. Sie werden in der Regel in Einscheibenreaktoren angewandt, d.h. ein einzelnes Substrat, wie z.B. ein Siliziumwafer mit 300 mm Durchmesser, wird in einer einzigen Elektrodenanordnung aus zwei Plasmaelektroden bearbeitet. Die HF-Generatorankopplung erfolgt dabei asymmetrisch, d.h. das Substrat liegt auf der Masseelektrode und als Gegenelektrode fungiert eine zweite an die Hochfrequenzspannung angeschlossene Elektrode, die außerhalb des Elektrodenspalts gut gegen Masse isoliert aufgebaut wird, um dort weitere parasitäre Plasmen zu vermeiden.

Für Spannungen in diesem Frequenzbereich und/oder Elektrodeneinheiten mit einer sehr großen Anzahl von gleichbeschalteten Plasmaelektroden, bspw. 20 oder mehr Plasmaelektroden, ist das Erzeugen eines symmetrischen Hochfrequenzplasmas problematisch. Insbesondere ist die erreichte Spannungsverteilung über die Elektrodeneinheit hinweg nicht mehr ausreichend homogen.

Um dieses Problem zu lösen sind aus dem Stand der Technik verschiedene Möglichkeiten bekannt. So beschreibt die US 5,733,511 A eine Anordnung, bei der jeder gleichbeschalteten Plasmaelektrode, die im vorliegenden Fall nebeneinander angeordnet sind, einzeln von außen eine Spannung über ein eigenes Koaxialkabel mit einer Länge von (2N+1)λ/4 (mit N=0, 1 ,2 ...) von einem Hochfrequenzspannungsgenerator, im folgenden HF-Generator genannt, und dem damit verbundenen Anpassungsnetzwerk (matching network, match network oder match box) zugeführt wird. Für eine große Anzahl von gleichbeschalteten Plasmaelektroden ist dies sehr aufwendig, bspw. durch die jeweils separate Vakuumdurchführung der Spannungszuführung in eine Behandlungskammer der Plasmabehandlungsanlage.

Auch die EP 2 299 479 A1 beschreibt eine Bearbeitungsvorrichtung, in der eine Mehrzahl von übereinander und parallel zueinander angeordneten und alternierend beschalteten Plasmaelektroden jeweils mit einer eigenen Spannungszuführungsleitung von außen durch die Bearbeitungskammerwand hindurch mit einer Spannung versorgt werden.

In der US 4,887,005 A wird eine Elektrodeneinheit beschrieben, bei der jede gleichbeschaltete Plasmaelektrode entweder über eine individuell einstellbare Induktivität oder Kapazität in einer separaten Zuleitung vom HF-Generator und dem Anpassungsnetzwerk mit Leistung versorgt wird, was jedoch ebenfalls sehr aufwändig ist, oder die einen Differential-Treibertransformator bzw. eine mittig angezapfte Spule aufweist, wobei jeweils ein Ende der Ausgangswicklung des Transformators bzw. jedes Ende der Spule mit einer bestimmten, einfachen der gleichbeschalteten Plasmaelektroden verbunden ist. Durch Nutzung weiterer Spulen kann die Leistung auch weiter aufgeteilt werden, so dass jeweils 2ⁿ (mit n=1, 2, 3 ...) Plasmaelektroden mit einer gleichen Leistung versorgt werden können. Jedoch liegt an den beiden Enden der mittig angezapften Spule oder des Transformators jeweils die halbe Ausgangsspannung mit entgegengesetztem Vorzeichen an. Die Ausgangsspannung des HF-Generators muss für eine große Anzahl von gleichbeschalteten Plasmaelektroden sehr hoch gewählt werden, was zu Problemen bei der Realisierung führt. Darüber hinaus sind auch hier alle zusätzlichen Bauelemente wie Induktivitäten, Kapazitäten, Transformator und mittig angezapfte Spule außerhalb der Behandlungskammer und damit außerhalb der Elektrodeneinheit angeordnet, was zu einer Vielzahl von Vakuum-Spannungsdurchführungen führt.

Aus der JP 2003 031504 A ist eine Plasmabearbeitungsanlage bekannt, bei der ein Substrat auf einer geerdeten Elektrode aufliegt und ein Plasma durch mehrere, über dem Substrat angeordnete stabförmige Elektroden erzeugt wird. Diese Elektroden entsprechen Antennen, die jeweils separat außerhalb der Plasmakammer mit einer von mehreren Spannungsquellen verbunden sind. Die an den einzelnen Antennen bereitgestellten Spannungen unterscheiden sich in der Frequenz und teilweise in der Leistung oder der Phase. Alle notwendigen Anpasseinheiten, Verteiler und Phasenschieber befinden sich außerhalb der Plasmakammer. Ziel der gesteuerten Spannungszuführungen ist die Vermeidung von negativen Auswirkungen von stehenden Wellen an den Antennen auf die Plasmabearbeitung.

Es ist daher Aufgabe der Erfindung, eine Elektrodeneinheit bereitzustellen, bei der allen gleichbeschalteten Plasmaelektroden nahezu dieselbe hochfrequente Spannung zugeführt wird, wobei die Nachteile des Standes der Technik vermieden oder verringert werden. Darüber hinaus ist es Aufgabe, eine Trägeranordnung zur Plasmabehandlung einer Vielzahl von Substraten bereitzustellen, bei der mindestens zwei derartige Elektrodeneinheiten vorteilhaft angeordnet sind.

Die Aufgabe wird gelöst durch eine Elektrodeneinheit gemäß Anspruch 1 und eine Trägeranordnung gemäß Anspruch 16. Bevorzugte Ausführungsformen finden sich in den Unteransprüchen.

Eine zur Plasmabehandlung einer Mehrzahl von Substraten in einer Behandlungskammer einer Plasmabehandlungsanlage geeignete Elektrodeneinheit weist mehrere Plasmaelektrodenpaare auf, die entlang einer ersten Richtung angeordnet sind. Dabei besteht jedes Plasmaelektrodenpaar aus einer ersten und einer zweiten Plasmaelektrode, die parallel zueinander und einander gegenüberliegend angeordnet und elektrisch voneinander isoliert sind. Vorzugsweise sind die ersten und zweiten Plasmaelektroden der Elektrodeneinheit alternierend entlang der ersten Richtung angeordnet. Jedes Plasmaelektrodenpaar ist geeignet, bei Vorliegen einer definierten Spannung zwischen der erste und der zweiten Plasmaelektrode ein Plasma in einem Plasmaraum zwischen der ersten und der zweiten Plasmaelektrode zu zünden. Die Elektrodeneinheit weist weiterhin mindestens ein internes elektrisches Zuführungsnetzwerk auf, das geeignet ist, innerhalb der Behandlungskammer jeder ersten Plasmaelektrode der Elektrodeneinheit eine erste Spannung und jeder zweiten Plasmaelektrode der Elektrodeneinheit eine zweite Spannung, die von der ersten Spannung verschieden ist, zuzuführen, wobei mindestens eine der ersten und der zweiten Spannung hochfrequent ist und eine Frequenz im Bereich zwischen 1 MHz und 100 MHz aufweist. Vorzugsweise sind sowohl die erste Spannung, als auch die zweite Spannung hochfrequente Spannungen. Das mindestens eine interne elektrische Zuführungsnetzwerk bildet gemeinsam mit den Plasmaelektroden, den zwischen den Plasmaelektroden erzeugten Plasmen und den Substraten im Betriebsfall, das heißt bei Anliegen einer zum Zünden und Aufrechterhalten der Plasmen ausreichenden elektrischen Spannung, ein internes elektrisches Netzwerk der Elektrodeneinheit, welches der Elektrodeneinheit inherent ist und von außen nur über die zugeführten Spannungen gesteuert werden kann.

Zur Einspeisung der ersten und der zweiten Spannung in das mindestens eine interne elektrische Zuführungsnetzwerk weist die Elektrodeneinheit weiterhin eine erste Anschlussklemme und eine zweite Anschlussklemme auf. Dabei ist die erste Anschlussklemme geeignet, die erste Spannung in das mindestens eine interne elektrische Zuführungsnetzwerk einzuspeisen, und die zweite Anschlussklemme ist geeignet, die zweite Spannung in das mindestens eine interne elektrische Zuführungsnetzwerk einzuspeisen. Dabei kann eine, von mindestens einem, außerhalb der Behandlungskammer angeordneten Generator bereitgestellten Hochfrequenzleistung über ohmsche Kontakte an die erste und die zweite Anschlussklemme übertragen werden. Alternativ kann auch eine Koppelanordnung eingesetzt werden, die kontaktlos durch kapazitive oder induktive Übertragung einer, von einem Generator bereitgestellten Hochfrequenzleistung die oben erwähnten Spannungen an den Anschlussklemmen generiert.

Dabei unterscheiden sich die erste und die zweite Spannung in mindestens einem der folgenden Merkmale: im Effektivwert, in der Frequenz oder der Phase. Vorzugsweise werden die erste und die zweite Spannung symmetrisch bezüglich Masse erzeugt, d.h. sie unterscheiden sich nicht in der Frequenz und im Effektivwert, aber durch eine um 180° unterschiedlicher Phasenlage. Jedoch ist auch eine asymmetrische Spannungszuführung möglich, bspw. indem die erste oder die zweite Spannung eine hochfrequente Spannung ist, während die andere Spannung gleich Null ist und Masse entspricht. In jedem Fall ist die aus der Differenz der elektrischen Potentiale der Plasmaelektroden eines Plasmaelektrodenpaares im Betriebsfall entstehende Elektrodenspannung eine hochfrequente Spannung mit einer definierten Frequenz im Bereich von 1 MHz bis 100 MHz.

Das mindestens eine interne elektrische Zuführungsnetzwerk der erfindungsgemäßen Elektrodeneinheit ist entsprechend der Anordnung der Plasmaelektroden in der Elektrodeneinheit, insbesondere der Anzahl und dem Abstand der Plasmaelektroden voneinander, und der Frequenz der ersten Spannung und/oder der zweiten Spannung ausgelegt, wobei es insbesondere an die Frequenz der Elektrodenspannung angepasst ist. Mit anderen Worten: Das mindestens eine interne elektrische Zuführungsnetzwerk ist so ausgelegt, dass die Elektrodeneinheit für den Betrieb mit einer konkreten ersten Spannung und einer konkreten zweiten Spannung angepasst ist. Im Betriebsfall ist das mindestens eine interne elektrische Zuführungsnetzwerk zusammen mit mindestens einem externen Anpassungsnetzwerk auf Resonanz und Anpassung des internen elektrischen Netzwerkes der Elektrodeneinheit und eine homogene Spannungsverteilung innerhalb der Elektrodeneinheit eingestellt. Das mindestens eine externe Anpassungsnetzwerk ist zwischen einem außerhalb der Behandlungskammer angeordneten Spannungsgenerator und mindestens einer der ersten oder zweiten Anschlussklemme angeordnet. Durch die konkrete Auslegung des mindestens einen internen elektrischen Zuführungsnetzwerks wird erreicht, dass zwischen der ersten und der zweiten Plasmaelektrode jedes Plasmaelektrodenpaares im Betriebsfall nahezu die gleiche Spannung vorliegt und an jedem Substrat eine nahezu gleiche Plasmaleistungsdichte erzeugt wird. Dies ist besonders vorteilhaft bei mehr als zehn Plasmaelektrodenpaaren in einer Elektrodeneinheit.

Das mindestens eine interne elektrische Zuführungsnetzwerk weist Zuleitungen zwischen der ersten bzw. der zweiten Anschlussklemme und mindestens zwei ersten bzw. mindestens zwei zweiten Plasmaelektroden und/oder Zwischenleitungen zwischen zwei benachbarten ersten bzw. zweiten Plasmaelektroden und jeweils einen Einspeispunkt in ein erstes bzw. zweites System aus miteinander verbundenen Zwischenleitungen und jeweils eine Verbindungsleitung zwischen der ersten bzw. der zweiten Anschlussklemme und dem zugehörigen Einspeispunkt auf. Dabei besteht die konkrete Auslegung des Zuführungsnetzwerkes in einer geeigneten Anordnung der Zuleitungen und/oder in geeigneten geometrischen Abmessungen der Zuleitungen und/oder der Zwischenleitungen und/oder der Verbindungsleitungen und/oder in einem geeigneten Material der Zuleitungen und/oder der Zwischenleitungen und/oder der Verbindungsleitungen und/oder in einer geeigneten Anordnung des Einspeispunktes in Bezug auf die Elektrodeneinheit entlang der ersten Richtung. Alle Zuleitungen und/oder Zwischenleitungen und/oder Verbindungsleitungen sind dabei reale, d.h. mit einer definierten parasitären Induktivität oder parasitären Kapazität behaftete, elektrische Leitungen, deren Einfluss auf das interne elektrische Netzwerk der Elektrodeneinheit bei Anliegen einer hochfrequenten Spannung mit einer Frequenz im Bereich zwischen 1 MHz und 100 MHz nicht vernachlässigbar ist.

Die parasitären Leitungsinduktivitäten oder-kapazitäten können bspw. durch die geeignete Wahl der geometrischen Abmessungen und/oder des Materials der Zuleitungen und/oder der Zwischenleitungen und/oder der Verbindungsleitungen beeinflusst werden.

Alle genannten Auslegungen des mindestens einen internen elektrischen Zuführungsnetzwerkes werden unten mit Bezug auf die Figuren erläutert.

Die Art und Weise der konkreten Auslegung des mindestens einen Zuführungsnetzwerkes, bspw. konkrete Materialien und konkrete Abmessungen der Leitungen im Zuführungsnetzwerk oder die konkrete Anordnung eines Einspeispunktes im Zuführungsnetzwerk, kann mit Hilfe von Rechenmodellen oder mit Hilfe von Simulationen evaluiert und entsprechend einer Anordnung von Plasmaelektroden in der Elektrodeneinheit ausgewählt werden.

Bei mehr als 50 Plasmaelektrodenpaaren in einer Elektrodeneinheit wird jedoch der Aufwand für die konkrete Auslegung des internen elektrischen Zuführungsnetzwerkes sehr hoch. Daher weist die erfindungsgemäße Trägeranordnung zur Plasmabehandlung einer Vielzahl von Substraten in einer Plasmabehandlungskammer mindestens zwei der oben beschriebenen, erfindungsgemäßen Elektrodeneinheiten auf. Vorzugsweise enthält dabei jede Elektrodeneinheit zwischen 20 und 30 Plasmaelektrodenpaare, besonders bevorzugt 25 Plasmaelektrodenpaare.

Im Nachfolgenden soll die Erfindung und ihre verschiedenen Ausführungsformen anhand von Ausführungsbeispielen und Figuren verdeutlicht werden.

Es zeigen:
- Fig. 1: eine schematische Darstellung einer Elektrodeneinheit gemäß dem Stand der Technik und ein elektrisches Ersatzschaltbild des internen elektrischen Netzwerkes dieser Elektrodeneinheit für eine niederfrequente Spannungsbeschaltung,
- Fig. 2: eine schematische Darstellung einer erfindungsgemäßen Elektrodeneinheit und ein elektrisches Ersatzschaltbild des internen elektrischen Netzwerkes dieser Elektrodeneinheit für eine hochfrequente Spannungsbeschaltung,
- Fig. 3: eine schematische Darstellung einer ersten erfindungsgemäßen Ausführungsform der Elektrodeneinheit mit zwei Zuführungsnetzwerken mit reihenförmiger Beschaltung der Plasmaelektroden und einer gleichsinnigen Ankopplung der Zuführungsnetzwerke und ein elektrisches Ersatzschaltbild des resultierenden internen elektrischen Netzwerkes,
- Fig. 4A: die Verteilung einer hochfrequenten Spannung über 10 gleichbeschaltete Plasmaelektroden hinweg für eine Elektrodeneinheit gemäß dem Stand der Technik bei gleichsinniger Ankopplung,
- Fig. 4B: die Verteilung einer hochfrequenten Spannung über 10 gleichbeschaltete Plasmaelektroden hinweg für die erste erfindungsgemäße Ausführungsform der Elektrodeneinheit,
- Fig. 5: eine schematische Darstellung einer zweiten erfindungsgemäßen Ausführungsform der Elektrodeneinheit mit zwei Zuführungsnetzwerken mit reihenförmiger Beschaltung der Plasmaelektroden und einer gegensinnigen Ankopplung der Zuführungsnetzwerke und ein elektrisches Ersatzschaltbild des resultierenden internen elektrischen Netzwerkes,
- Fig. 6A: die Verteilung einer hochfrequenten Spannung über 10 gleichbeschaltete Plasmaelektroden hinweg für eine Elektrodeneinheit gemäß dem Stand der Technik bei gegensinniger Ankopplung,
- Fig. 6B: die Verteilung einer hochfrequenten Spannung über 10 gleichbeschaltete Plasmaelektroden hinweg für die zweite erfindungsgemäße Ausführungsform der Elektrodeneinheit,
- Fig. 7: eine schematische Darstellung einer dritten erfindungsgemäßen Ausführungsform der Elektrodeneinheit mit zwei Zuführungsnetzwerken mit reihenförmiger Beschaltung der Plasmaelektroden und beliebig angeordneten Einspeispunkten und ein elektrisches Ersatzschaltbild des resultierenden internen elektrischen Netzwerkes,
- Fig. 8: eine schematische Darstellung einer vierten erfindungsgemäßen Ausführungsform der Elektrodeneinheit mit zwei Zuführungsnetzwerken mit reihenförmiger Beschaltung der Plasmaelektroden und mittig angeordneten Einspeispunkten und ein elektrisches Ersatzschaltbild des resultierenden internen elektrischen Netzwerkes,
- Fig. 9: eine schematische Darstellung einer fünften erfindungsgemäßen Ausführungsform der Elektrodeneinheit mit zwei Zuführungsnetzwerken mit baumförmiger Beschaltung der Plasmaelektroden und ein elektrisches Ersatzschaltbild des resultierenden internen elektrischen Netzwerkes,
- Fig. 10: eine schematische Darstellung einer sechsten erfindungsgemäßen Ausführungsform der Elektrodeneinheit mit zwei Zuführungsnetzwerken mit reihen- und baumförmiger Beschaltung der Plasmaelektroden und ein elektrisches Ersatzschaltbild des resultierenden internen elektrischen Netzwerkes,
- Fig. 11: eine schematische Darstellung einer siebten erfindungsgemäßen Ausführungsform der Elektrodeneinheit mit einem als Hochfrequenzleitung ausgebildeten Zuführungsnetzwerk, wobei die erste und die zweite Anschlussklemme an dem gleichen Ende der Hochfrequenzleitung liegen, und ein elektrisches Ersatzschaltbild des resultierenden internen elektrischen Netzwerkes,
- Fig. 12: eine schematische Darstellung einer achten erfindungsgemäßen Ausführungsform der Elektrodeneinheit mit einem als Hochfrequenzleitung ausgebildeten Zuführungsnetzwerk, wobei die erste und die zweite Anschlussklemme an entgegengesetzten Enden der Hochfrequenzleitung liegen, und ein elektrisches Ersatzschaltbild des resultierenden internen elektrischen Netzwerkes,
- Fig. 13: eine schematische Darstellung einer neunten erfindungsgemäßen Ausführungsform der Elektrodeneinheit mit zwei Zuführungsnetzwerken und einer dielektrischen Schicht auf einer Plasmaelektrode,
- Fig. 14A: eine schematische Darstellung einer ersten Ausführungsform einer Trägeranordnung mit erfindungsgemäßen Elektrodeneinheiten in einer ersten Querschnittsebene,
- Fig. 14B: eine schematische Darstellung der ersten Ausführungsform einer Trägeranordnung in einer zweiten Querschnittsebene senkrecht zur ersten Querschnittsebene,
- Fig. 15A: eine schematische Darstellung einer zweiten Ausführungsform einer Trägeranordnung mit erfindungsgemäßen Elektrodeneinheiten in einer ersten Querschnittsebene, und
- Fig. 15B: eine schematische Darstellung der zweiten Ausführungsform einer Trägeranordnung in einer zweiten Querschnittsebene senkrecht zur ersten Querschnittsebene

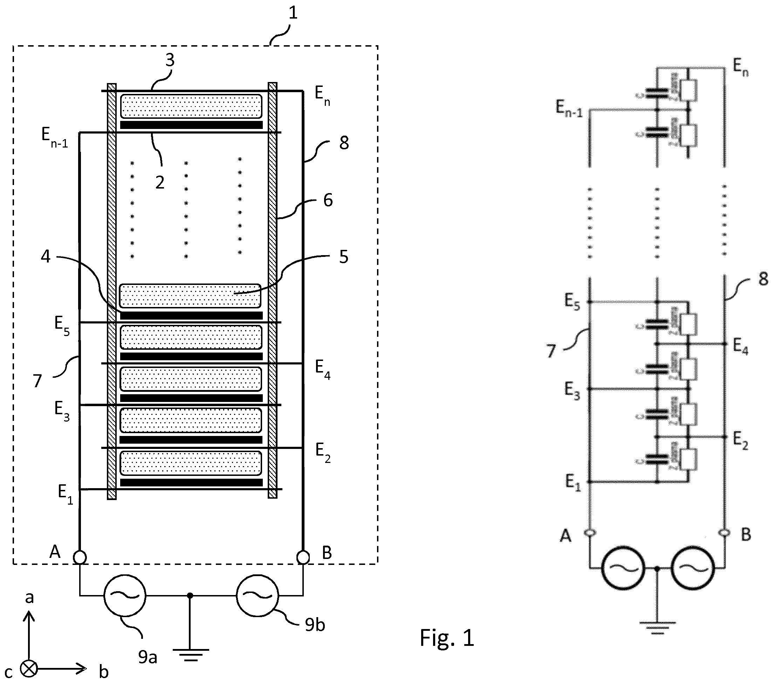

**Figur** 1 zeigt eine Elektrodeneinheit 1 gemäß dem Stand der Technik, die zur Plasmabehandlung einer Mehrzahl von Substraten 4 in einer Behandlungskammer einer Plasmabehandlungsanlage geeignet ist. Die Elektrodeneinheit 1 kann fest in der Behandlungskammer montiert sein oderals Ganzes in diese hinein und aus dieser heraus bewegt werden. Darüber hinaus besteht auch die Möglichkeit, dass die Elektrodeneinheit 1 während der Plasmabehandlung in der Kammer geradlinig, rotierend oder andersartig gleichförmig oder ungleichförmig bewegt wird. Die Substrate 4 sind nicht Bestandteil der Elektrodeneinheit 1.

Die Elektrodeneinheit 1 weist eine Vielzahl von Plasmaelektrodenpaaren auf, die entlang einer ersten Richtung (a-Achse) angeordnet sind. Jedes Plasmaelektrodenpaar besteht aus einer ersten Plasmaelektrode 2 und einer zweiten Plasmaelektrode 3, die parallel zueinander und einander gegenüberliegend angeordnet und voneinander elektrisch isoliert sind. Vorzugsweise sind die ersten und die zweiten Plasmaelektroden 2, 3 alternierend entlang der ersten Richtung angeordnet und erstrecken sich jeweils mit einer Fläche, auf der ein Substrat 4 während einer Plasmabearbeitung aufliegt, senkrecht zur ersten Richtung, d.h. in einer Ebene, die parallel zu einer von den zwei anderen Richtungen (b- und c-Achse) eines dreidimensionalen kartesischen Koordinatensystems, zu dem auch die erste Richtung gehört, aufgespannten Ebene ist. Jedoch können sich die Flächen der ersten Plasmaelektroden 2 bzw. der zweiten Plasmaelektroden 3 auch in einer Ebene erstrecken, die von der ersten Richtung und einer weiteren Richtung aufgespannt wird, so dass die jeweiligen Plasmaelektroden nebeneinander entlang der ersten Richtung angeordnet sind. Die Plasmaelektroden eines Plasmaelektrodenpaares liegen sich dann entlang einer der anderen beiden Richtungen des kartesischen Koordinatensystems gegenüber. Die ersten und die zweiten Plasmaelektroden 2, 3 bestehen aus einem elektrisch leitfähigen Material, bspw. Graphit oder Aluminium, so dass bei Anliegen einer definierten Spannung zwischen der ersten und der zweiten Plasmaelektrode 2, 3 eines Plasmaelektrodenpaares ein Plasma in einem Plasmaraum 5 gezündet wird.

Die Fläche der Plasmaelektroden 2, 3 ist üblicherweise geringfügig größerals die Fläche der zu behandelnden Substrate 4, wobei die äußere Form (der Umriss, die Kontur) der Fläche der Plasmaelektroden 2, 3 in etwa der der Substrate 4 entspricht Jedoch kann bei elektrisch gut leitenden Substraten 4 auch nur ein Teil des Substrates 4 mit der jeweiligen Plasmaelektrode in Kontakt stehen, wobei diese Plasmaelektrode dann eine beliebige Form aufweisen kann. Beispielsweise weist eine Plasmaelektrode 2, 3 eine Fläche von (200x200) mm² bei einer Größe des Substrates 4 von (156x156) mm² auf. Der Abstand zwischen der ersten Plasmaelektrode 2 und der zweiten Plasmaelektrode 3 eines Plasmaelektrodenpaares liegt im Bereich zwischen 3 mm und 50 mm.

Die Elektrodeneinheit 1 weist n Plasmaelektroden 2, 3 auf, wobei n üblicherweise eine gerade Zahl zwischen 10 und 200 ist. In diesem Fall gibt es n/2 erste Plasmaelektroden 2 (in der Figur mit E₁, E₃, E₅, ..., Eₙ₋₁ bezeichnet) und n/2 zweite Plasmaelektroden 3 (in der Figur mit E₂, E₄, ..., Eₙ bezeichnet). Es kann jedoch auch eine ungerade Anzahl von Plasmaelektroden 2, 3 vorhanden sein. Die einzelnen Plasmaelektroden 2, 3 sind voneinander entlang der ersten Richtung durch isolierende Träger 6 beabstandet und werden von diesen getragen. Die Träger 6 können verschiedene Formen aufweisen und können bspw. mehrere stabförmige Träger, die sich jeweils entlang der ersten Richtung erstrecken, sein oder als ein Gehäuse ausgebildet sein, in dem die Plasmaelektroden angeordnet sind und das auf mindestens einer Seite Öffnungen zum Einführen der Substrate 4 aufweist.

Alle ersten Plasmaelektroden 2, d.h. E₁ bis Eₙ₋₁, sind über eine gemeinsame erste Verteilleitung 7 mit einer ersten Anschlussklemme A verbunden, während alle zweiten Plasmaelektroden 3, d.h. E₂ bis Eₙ, über eine gemeinsame zweite Verteilleitung 8 mit einer zweiten Anschlussklemme B verbunden sind. Zwei Generatoren 9a und 9b, die zwei Spannungen gleicher Frequenz und Amplitude, aber unterschiedlicher Phasenlage (bspw. 180° Phasenversatz) bezüglich Masse generieren, werden an die Anschlussklemmen A und B angeschlossen. Statt der zwei Generatoren können auch Koppelanordnungen eingesetzt werden, die kontaktlos auf induktivem oder kapazitivem Weg eine Leistung zur Elektrodenanordnung hin übertragen und zwei um 180° phasenversetzte Spannungen bezüglich Masse aus ihrem jeweiligen elektrischen Koppelnetzwerk an die Klemmen A und B liefern, die mit den Verteilleitungen 7, 8 weiter verbunden sind.

Gemäß dem Stand der Technik sind die erste und die zweite Verteilleitung 7, 8 üblicherweise als massive Graphitstäbe oder Platten bzw. Kontaktstücke aus Graphit mit einem Querschnitt (in der b-c-Ebene) von bspw. (20x5) mm² ausgebildet. Die Länge der Verteilleitungen 7, 8 entlang der ersten Richtung (a-Achse) ergibt sich aus der Anzahl der Plasmaelektroden 2, 3 bzw. dem Abstand zwischen der Anschlussklemme A bzw. B und der letzten Plasmaelektrode 2 bzw. 3, die über die jeweilige Verteilleitung 7 bzw. 8 mit Spannung versorgt wird.

Für niederfrequente Spannungen, die an die Plasmaelektroden 2, 3 angelegt werden, d.h. für Spannungen mit einer Frequenz im Bereich von 10 Hz bis 1000 kHz, wirken die Verteilleitungen 7 und 8 jeweils als ideale Leiter, deren parasitären Induktivitäten und parasitären Kapazitäten vernachlässigt werden können. Damit können alle ersten Plasmaelektroden 2 bzw. alle zweiten Plasmaelektroden 3 als parallelgeschaltet betrachtet werden und weisen die gleiche Spannung auf. Somit kann das interne elektrische Netzwerk der Elektrodeneinheit 1 durch das rechts in Fig. 1 dargestellte elektrische Ersatzschaltbild gekennzeichnet werden, wobei das zwischen den Plasmaelektroden eines Plasmaelektrodenpaares gezündete Plasma jeweils als Plasmaimpedanz Z_plasma und der Plattenkondensator, der durch die Plasmaelektroden des Plasmaelektrodenpaares gebildet wird, jeweils als Kapazität C dargestellt sind. Bei Vernachlässigung anlagenbedingter Inhomogenitäten weisen somit alle in der Elektrodeneinheit 1 gezündeten Plasmen die gleichen Plasmaparameter auf, so dass alle Substrate 4 homogen bearbeitet werden können.

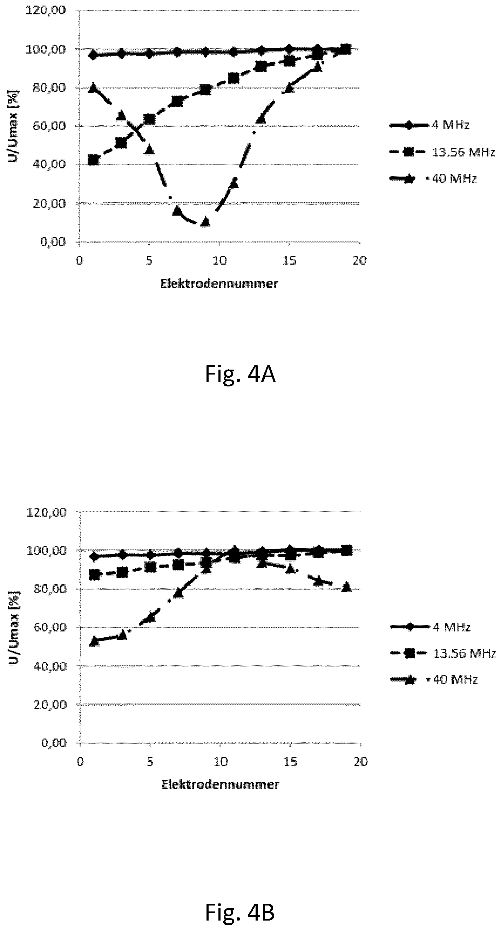

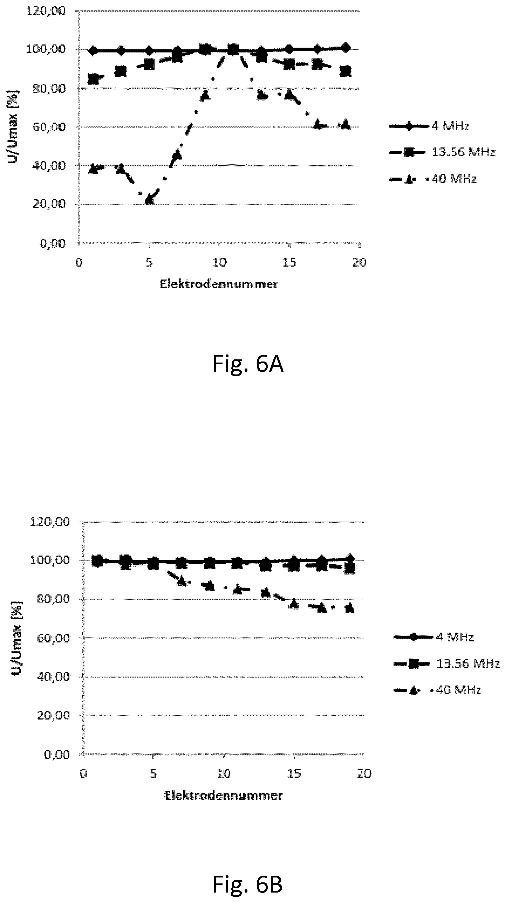

Für Plasmaprozesse mit Spannungen mit höheren Frequenzen, bspw. 13,56 MHz oder 40 MHz, und/oder Elektrodeneinheiten mit einer sehr großen Anzahl von gleichbeschalteten Plasmaelektroden, bspw. 10 oder mehr Plasmaelektroden, ist die so erreichte Spannungsverteilung jedoch nicht mehr ausreichend homogen. Dies wird später mit Bezug auf die Figuren 4A und 6A näher erläutert.

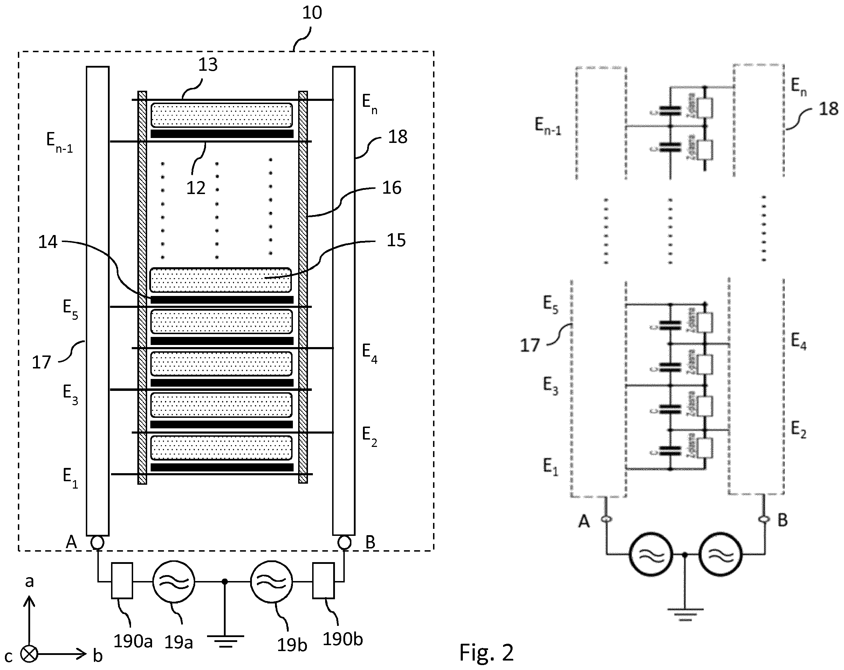

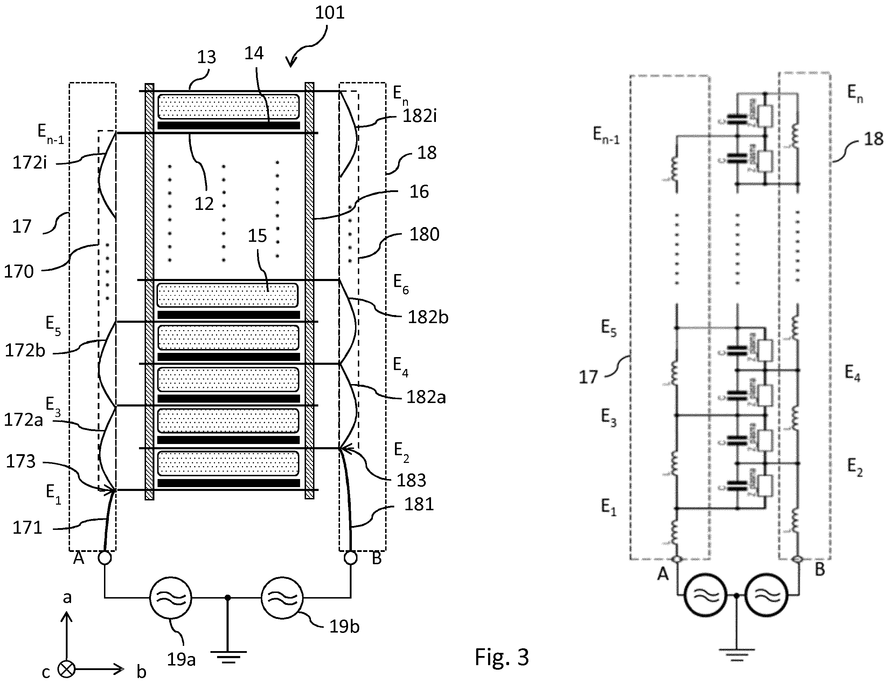

**Figur** 2 zeigt nunmehr eine erfindungsgemäße Elektrodeneinheit 10, die erste Plasmaelektroden 12, zweite Plasmaelektroden 13, Substrate 14, Plasmaräume 15, isolierende Träger 16 sowie Anschlussklemmen A und B enthält und diesbezüglich keine Unterschiede zu der Elektrodeneinheit 1 aus Fig. 1 aufweist. Jedoch ist die Elektrodeneinheit 10 zu einer Plasmabehandlung der Substrate 14 geeignet, bei der das Plasma mit Hilfe von zwei hochfrequenten Spannungen, die von zwei Hochfrequenzspannungsgeneratoren 19a und 19b bezüglich Masse bereitgestellt werden, gezündet wird. Vorzugsweise sind die beiden Spannungen gleich, jedoch phasenverschoben, vorzugsweise um 180°. Die Frequenz dieser Spannungen liegt im Bereich zwischen 1 MHz und 100 MHz, vorzugsweise im Bereich zwischen 10 MHz und 40 MHz, bspw. bei 13,56 MHz. Die Spannungen werden von den Hochfrequenzspannungsgeneratoren 19a, 19b jeweils über ein dazugehöriges externes Anpassungsnetzwerk 190a, 190b an die erste Anschlussklemme A bzw. an die zweite Anschlussklemme B übertragen. Die externen Anpassungsnetzwerke, die nicht Bestandteil der Elektrodeneinheit 10 sind, werden aus Gründen der Übersichtlichkeit in den Figuren 3, 5 und 7 bis 13 nicht dargestellt, liegen dort aber genauso vor.

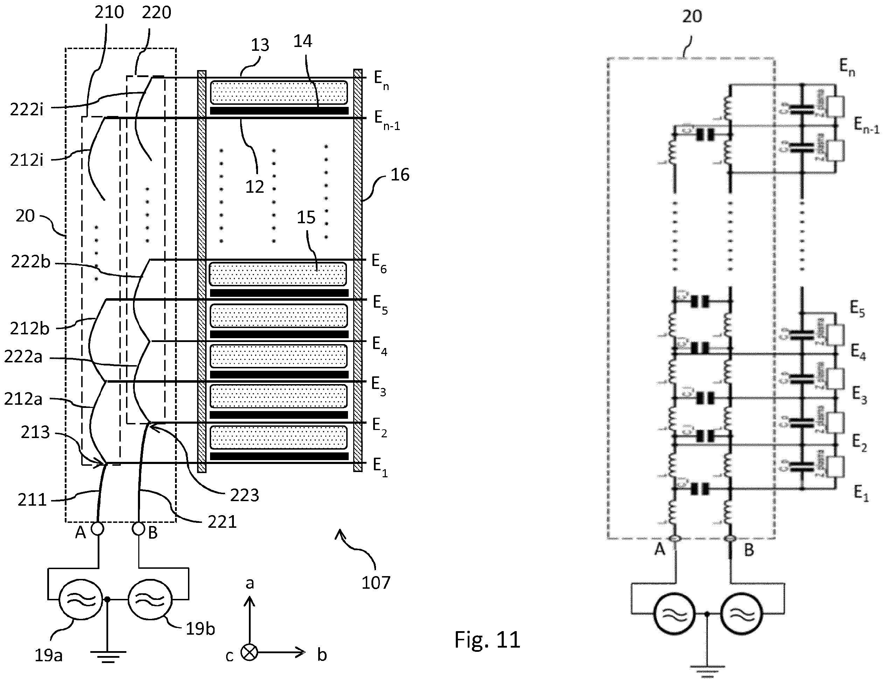

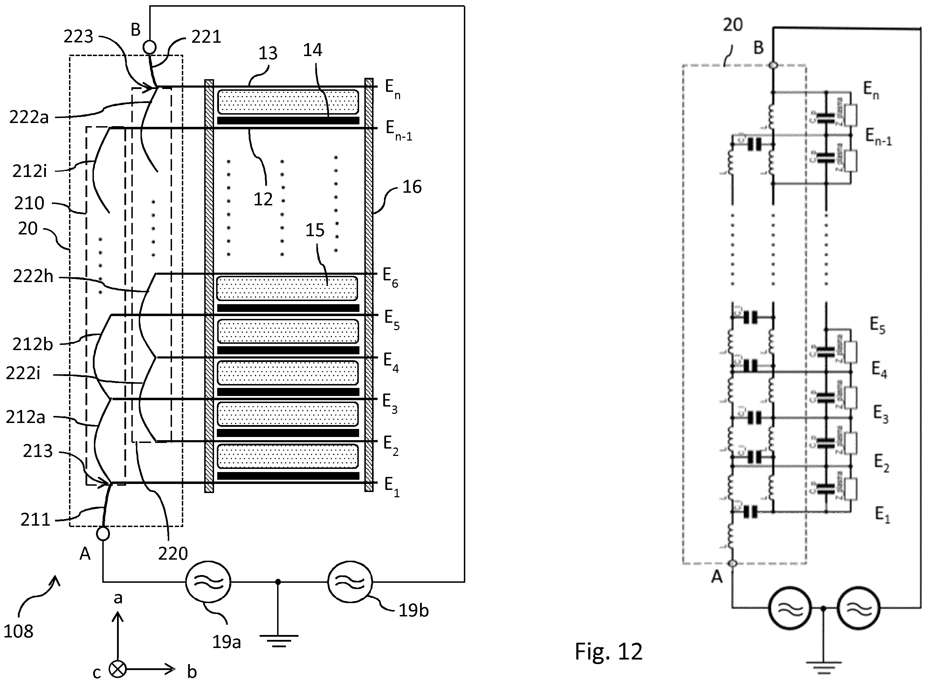

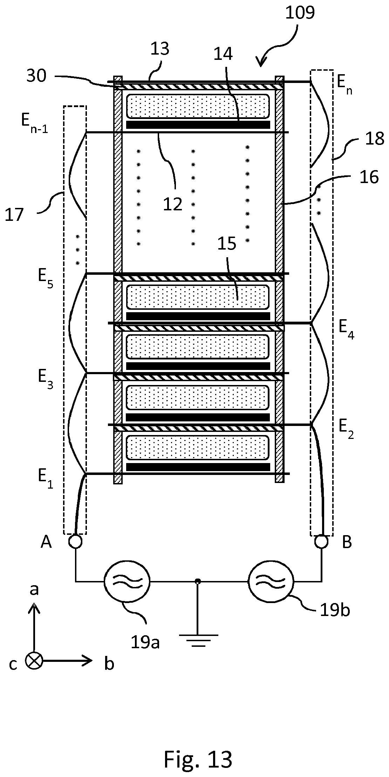

Um im Betriebsfall eine homogene Plasmazündung über alle Plasmaelektrodenpaare der Elektrodeneinheit 10 zu erreichen, weist die Elektrodeneinheit 10 mindestens ein internes elektrisches Zuführungsnetzwerk auf, das eine erste Spannung, die vom Generator 19a und dem externen Anpassungsnetzwerk 190a bereitgestellt wird, allen ersten Plasmaelektroden 12 und eine zweite Spannung, die vom Generator 19b und dem externen Anpassungsnetzwerk 190b bereitgestellt wird, allen zweiten Plasmaelektroden 13 zuführt. In Figur 2 ist eine Ausführungsform mit zwei internen elektrischen Zuführungsnetzwerken 17, 18 dargestellt. Ausführungsformen mit nur einem internen elektrischen Zuführungsnetzwerk 20 werden mit Bezug auf die Figuren 11 und 12 näher erläutert. Dabei besteht jedes, in der Elektrodeneinheit 10 integrierte Zuführungsnetzwerk 17, 18 oder 20 aus realen, mit parasitären Induktivitäten und ggf. auch parasitären Kapazitäten versehenen Leitungen, deren Abmessungen, Materialien, Anordnungen und internen Verbindungen so gestaltet sind, dass im Betriebsfall zwischen den Plasmaelektroden 12, 13 jedes Plasmaelektrodenpaares nahezu die gleiche hochfrequente Elektrodenspannung vorliegt. "Nahezu" verdeutlicht, dass selbst bei sehr guter Anpassung der Netzwerke geringe Spannungsunterschiede bestehen können, die jedoch im Sinne der Plasmabehandlung der Substrate 14 tolerabel oder durch weitere Maßnahmen, wie z.B. weitere eingefügte Kapazitäten oder Induktivitäten, wie sie beispielhaft mit Bezug auf Fig. 13 beschrieben werden, auf ein tolerables Maß reduzierbar sind. Im Betriebsfall werden die externen Anpassungsnetzwerke 190a und 190b so eingestellt, dass Resonanz zwischen dem internen elektrischen Netzwerk der Elektrodeneinheit 10 und den externen Anpassungsnetzwerken 190a, 190b entsteht und alle Netzwerke aufeinander angepasst sind.

Welche Spannungsunterschiede für eine konkrete Plasmabehandlung von Substraten tolerabel ist, hängt dabei von den Anforderungen, die an die Homogenität der Plasmabehandlung über die Vielzahl von Substraten hinweg gestellt werden, ab. Das heißt: Welche Spannungsunterschiede noch tolerabel sind, hängt wesentlich von den durch einen Nutzer der Plasmabehandlungsanlage für einen konkreten Plasmabehandlungsprozess vorgegebenen Homogenitätszielen ab. In der Solarzellenproduktion wird bspw. im Allgemeinen davon ausgegangen, dass eine Abweichung von 10% oder kleiner zwischen den Elektrodenspannungen innerhalb der Elektrodeneinheit tolerabel ist.

Dazu werden die in dem mindestens einen internen elektrischen Zuführungsnetzwerk vorhandenen Leitungen, d.h. Zuleitungen und/oder Zwischenleitungen und/oder Verbindungsleitungen, nicht mehr wie im Stand der Technik als massive Gebilde aus Graphit ausgeführt, sondern z.B. als Metallstreifen mit einer Dicke im Bereich von 0.1 mm bis 5 mm, vorzugsweise im Bereich von 0,2 mm bis 0,5 mm, und einer Breite im Bereich von 1 mm bis 100 mm, vorzugsweise 20 mm bis 60 mm. Die Dicke und die Breite kennzeichnen die Querschnittsfläche der Leitung, während eine Länge der Leitung entlang der Stromflussrichtung gemessen wird. Die Länge der in einem Netzwerk eingesetzten Metallstreifen kann dabei variieren und ist von der Art der Leitung abhängig.

Die Metallstreifen bestehen vorzugsweise aus einem hochleitfähigen Material wie z.B. Aluminium, Kupfer, Silber oder versilbertem Kupfer (Kupfer mit einer Silberschicht auf der Oberfläche) Die Auswahl des Materials hängt dabei nicht nur von den elektrischen Bedingungen im internen elektrischen Netzwerk der Elektrodeneinheit im Betriebsfall, sondern auch von den chemischen Eigenschaften der genannten Materialien bezüglich der in der Behandlungskammer und insbesondere im Plasma vorhandenen Stoffe, Moleküle, Radikale etc.

Beispielsweise bestehen die Metallstreifen aus Kupfer und weisen jeweils eine Dicke von 0,25 mm und eine Breite von 30 mm auf.

Bestehen die Metallstreifen aus Aluminium, so weisen sie jeweils eine Dicke von 0,5 mm und eine Breite von 50 mm auf.

In der in Figur 2 dargestellten Ausführungsform wird die erste Spannung von der Anschlussklemme A in ein erstes Zuführungsnetzwerk 17 eingespeist und von diesem jeder erster Plasmaelektrode 12 zur Verfügung gestellt, während die zweite Spannung von der Anschlussklemme B in ein zweites Zuführungsnetzwerk 18 eingespeist und von diesem jeder zweiten Plasmaelektrode 13 zur Verfügung gestellt wird.

Mit Bezug auf die folgenden Figuren sollen Ausführungsformen der erfindungsgemäßen Elektrodeneinheit 10 mit zwei internen elektrischen Zuführungsnetzwerken 17, 18 vorgestellt werden, wobei die beiden Zuführungsnetzwerke 17, 18 jeweils räumlich und elektrisch voneinander getrennt sind. Das bedeutet, dass der Abstand der beiden Zuführungsnetzwerke 17, 18 voneinander so groß ist, dass eine kapazitive und induktive Kopplung zwischen den Leitungen der beiden Zuführungsnetzwerke 17, 18 vernachlässigbar ist. Dieser Abstand liegt vorzugsweise im Bereich von 100 mm bis 500 mm, bspw. bei 200 mm. Die räumliche und elektrische Trennung kann bspw. durch eine Anordnung der beiden Zuführungsnetzwerke 17, 18 auf verschiedenen Seiten der Elektrodeneinheit 10 in Bezug auf eine Richtung, die senkrecht zur ersten Richtung verläuft, realisiert werden. Bspw. sind die beiden Zuführungsnetzwerke 17, 18, so wie in Figur 2 dargestellt, auf entgegengesetzten Seiten der Elektrodeneinheit 10 mit Bezug auf die b-Achse angeordnet.

**Figur** 3 zeigt eine erste Ausführungsform 101 der Elektrodeneinheit mit zwei internen elektrischen Zuführungsnetzwerken 17, 18. Die erste Spannung wird im ersten Zuführungsnetzwerk 17 von der ersten Anschlussklemme A über eine erste Verbindungsleitung 171 in ein erstes System 170 aus miteinander verbundenen ersten Zwischenleitungen 172a-172i eingespeist. Die Zwischenleitung 172a verbindet dabei die in der ersten Richtung zuerst angeordnete erste Plasmaelektrode 12 (E₁) mit der als nächste entlang der ersten Richtung angeordneten ersten Plasmaelektrode 12 (E₃), die Zwischenleitung 172b verbindet diese erste Plasmaelektrode 12 (E₃) wiederum mit der nächsten entlang der ersten Richtung angeordneten ersten Plasmaelektrode 12 (E₅) und so weiter, bis schließlich auch die letzte entlang der ersten Richtung angeordnete erste Plasmaelektrode 12 (Eₙ₋₁) durch die Zwischenleitung 172i mit der davor angeordneten ersten Plasmaelektrode 12 verbunden ist. Dies entspricht einer Reihenschaltung aus der Verbindungsleitung 171 und den jeweiligen Zwischenleitungen 172a-172i, wobei jede dieser Leitungen durch eine parasitäre Induktivität L im elektrischen Ersatzschaltbild (rechte Seite der Fig. 3) gekennzeichnet ist. Damit wird die als Erste entlang der ersten Richtung angeordnete erste Plasmaelektrode 12 (E₁) über die erste Verbindungsleitung 171 mit Spannung versorgt, die als Zweite entlang der ersten Richtung angeordnete erste Plasmaelektrode 12 (E₃) über die Reihenschaltung aus erster Verbindungsleitung 171 und erster Zwischenleitung 172a mit Spannung versorgt, die als Dritte entlang der ersten Richtung angeordnete erste Plasmaelektrode 12 (E₅) über die Reihenschaltung aus erster Verbindungsleitung, erster Zwischenleitung 172a und erster Zwischenleitung 172b mit Spannung versorgt usw. In gleicher Weise werden die zweiten Plasmaelektroden 13 (E₂ bis Eₙ) über eine zweite Verbindungsleitung 181 und ein zweites System 180 von zweiten Zwischenleitungen 182a-182i, die zusammen das zweite Zuführungsnetzwerk 18 bilden, von der zweiten Anschlussklemme B aus mit Spannung versorgt. Der erste Einspeispunkt 173, der den Anschluss der ersten Verbindungsleitung 171 an das erste System 170 kennzeichnet, liegt dabei auf der Höhe der als Erste entlang der ersten Richtung in der Elektrodeneinheit 101 angeordneten ersten Plasmaelektrode 12 (E₁). In gleicher Weise liegt der zweite Einspeispunkt 183, der den Anschluss der zweiten Verbindungsleitung 181 an das zweite System 180 kennzeichnet, auf der Höhe der als Erste entlang der ersten Richtung in der Elektrodeneinheit 101 angeordneten zweiten Plasmaelektrode 13 (E₂). Dies wird als gleichsinnige Beschaltung oder gleichsinnige Generatorankopplung bezeichnet. Die hochfrequente Spannung wird dabei in beiden Zuführungsnetzwerken 17, 18 zwischen den jeweiligen Plasmaelektroden 12, 13 in die gleiche Richtung, hier in die erste Richtung, weitergeleitet.

Die Verbindungsleitungen 171, 181 sowie die Zwischenleitungen 172a-172i, 182a-182i können, wie bereits erwähnt, als Metallstreifen aus besonders gut leitenden Materialien wie Kupfer oder Aluminium ausgebildet sein. Die Zwischenleitungen 172a-172i, 182a-182i können dabei eine Länge aufweisen, die größer als der Abstand zwischen zwei entlang der ersten Richtung benachbarten gleichbeschalteten Plasmaelektroden 12, 13, also bspw. größer als der Abstand zwischen der Elektrode E₁ und der Elektrode E₃, ist. Dieser Abstand beträgt zwischen 6 mm und 100 mm, so wie auch bei der Elektrodeneinheit gemäß dem Stand der Technik. Auch die Länge der Verbindungsleitungen 171, 181 kann gegenüber dem Abstand der jeweiligen Anschlussklemme A, B von der als Erste innerhalb der Elektrodeneinheit 101 angeordneten ersten bzw. zweiten Plasmaelektrode 12, 13 größer sein. Durch Einsatz induktivitätsarmer Verbindungs- und Zwischenleitungen gegenüber den Verteilleitungen in der Elektrodeneinheit gemäß dem Stand der Technik werden die Unterschiede in den Elektrodenspannungen über die Elektrodeneinheit hinweg stark vermindert.

Dies ist in den **Figuren 4A und 4B** dargestellt. Diese Figuren beruhen auf Messungen der anliegenden Hochfrequenzspannung an gleichbeschalteten Plasmaelektroden einer Elektrodeneinheit für unterschiedliche Frequenzen der Spannung und decken sich mit Simulationen des Spannungsverlaufs mit üblichen Simulationsprogrammen für elektronische Schaltungen, wie bspw. PSPICE, über eine Anzahl gleichbeschalteter Plasmaelektroden hinweg und zeigen die Spannungsabweichung der an einer konkreten dieser Plasmaelektroden anliegenden Spannung im Verhältnis zur höchsten, an einer dieser Plasmaelektroden anliegenden Spannung jeweils für eine Frequenz von 4 MHz, 13,56 MHz oder 40 MHz. In Fig. 4A ist die Spannungsverteilung für eine Elektrodeneinheit gemäß dem Stand der Technik mit 20 Plasmaelektroden, d.h. über 10 gleichbeschaltete Plasmaelektroden hinweg, dargestellt, während Fig. 4B die Spannungsverteilung für die erste Ausführungsform der erfindungsgemäßen Elektrodeneinheit mit 20 Plasmaelektroden zeigt. Die erste und die zweite Plasmaelektrode jedes Plasmaelektrodenpaares sind dabei in einem Abstand von 15 mm zueinander angeordnet. Die gleichbeschalteten Plasmaelektroden, die Abmessungen von (200 x 200) mm² aufweisen, werden jeweils gleichsinnig beschaltet.

Wie zu sehen ist, liegt die Spannungsabweichung innerhalb der Elektrodeneinheit gemäß dem Stand der Technik für eine Frequenz von 4 MHz bei ca. 4% und ist damit noch tolerabel. Für höhere Frequenzen liegt jedoch eine stark inhomogene Spannungsverteilung vor, die nicht mehr tolerabel ist, da sie keine über die Elektrodeneinheit hinweg homogene Plasmabehandlung der Substrate erlaubt. Demgegenüber ist die Spannungsverteilung für 13,56 MHz in der ersten Ausführungsform der erfindungsgemäßen Elektrodeneinheit bereits stark verbessert und kann selbst bei 13.56 MHz toleriert werden.

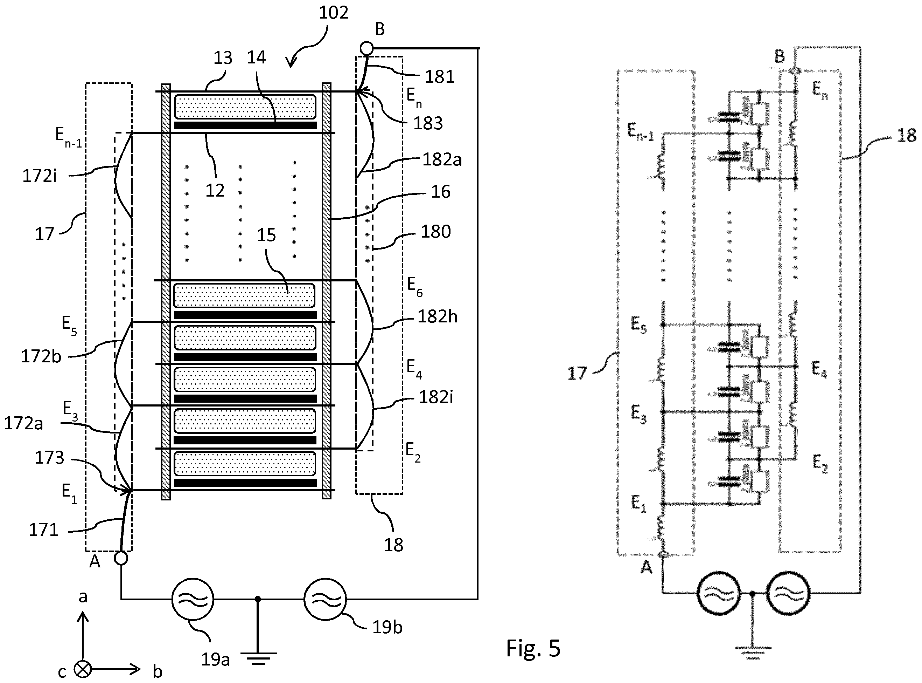

Eine zweite Ausführungsform 102 der erfindungsgemäßen Elektrodeneinheit sowie das dazugehörige elektrische Ersatzschaltbild sind in **Figur 5** dargestellt. Dabei weist die Elektrodeneinheit wieder ein erstes Zuführungsnetzwerk 17, das gleich zu dem in der ersten Ausführungsform ausgestaltet ist, und ein zweites Zuführungsnetzwerk 18 auf. Das zweite Zuführungsnetzwerk 18 ist ähnlich zu dem der ersten Ausführungsform gebildet, jedoch liegt der zweite Einspeispunkt 183 nun auf der Höhe derjenigen zweiten Plasmaelektrode 13, die entlang der ersten Richtung (a-Achse) als Letzte in der Elektrodeneinheit 102 angeordnet ist. Dies ist die Plasmaelektrode Eₙ. Damit ist die zweite Zwischenleitung 182a, die die letzte zweite Plasmaelektrode 13 (Eₙ) mit der vorhergehenden zweiten Plasmaelektrode 13 (Eₙ₋₂) verbindet, die erste Zwischenleitung im zweiten System 180, während die Zwischenleitung 182i die Letzte im zweiten System 180 ist und die zweiten Plasmaelektroden 13, die als die ersten zwei in der Elektrodeneinheit 102 entlang der ersten Richtung angeordnet sind (E₂ und E₄), miteinander verbindet.

Wie in Fig. 5 dargestellt, kann die zweite Anschlussklemme B ebenfalls auf der mit Bezug auf die erste Richtung anderen Seite der Elektrodeneinheit 102 angeordnet sein. Jedoch kann die zweite Anschlussklemme B genauso wie in der ersten Ausführungsform 101 am unteren Ende der Elektrodeneinheit angeordnet sein, wobei dann die Verbindungsleitung 181 entsprechend innerhalb des zweiten Zuführungsnetzwerkes 18 bis zur letzten zweiten Plasmaelektrode 13 (Eₙ) und damit bis zum zweiten Einspeispunkt 183 geführt wird.

Diese Anordnung der zweiten Ausführungsform 102 wird als gegensinnige Beschaltung oder gegensinnige Generatorankopplung bezeichnet. Die hochfrequente Spannung wird dabei im ersten Zuführungsnetzwerk 17 entlang der ersten Richtung und im zweiten Zuführungsnetzwerk 18 entlang einer zweiten Richtung, die der ersten Richtung entgegengesetzt ist, zwischen den jeweiligen Plasmaelektroden 12, 13 weitergeleitet. Damit durchläuft ein Strom, der während der Plasmabehandlung fließt, für jedes Plasmaelektrodenpaar gleich viele parasitäre Leitungsinduktivitäten L und parasitären Kapazitäten zwischen den Anschlussklemmen A und B, wodurch die Homogenität der Spannungsverteilung weiter erhöht wird.

Dies ist in den **Figuren 6A und 6B** deutlich zu erkennen. Fig. 6A zeigt wieder die Spannungsverteilung über 10 gleichbeschaltete Plasmaelektroden einer Elektrodeneinheit gemäß dem Stand der Technik, während Fig. 6B die Spannungsverteilung für die zweite Ausführungsform der erfindungsgemäßen Elektrodeneinheit mit 10 gleichbeschalteten Plasmaelektroden zeigt. Die erste und die zweite Plasmaelektrode jedes Plasmaelektrodenpaares sind dabei wieder in einem Abstand von 15 mm zueinander angeordnet. Die gleichbeschalteten Plasmaelektroden, die Abmessungen von (200 x 200) mm² aufweisen, werden jeweils gegensinnig an den oder die HF-Spannungsgeneratoren angekoppelt.

Auch hier ist eine starke Spannungsinhomogenität für die Elektrodeneinheit gemäß dem Stand der Technik für die Frequenzen 13,56 MHz und 40 MHz zu sehen (Fig. 6A), während die Spannungsverteilung für die zweite Ausführungsform der erfindungsgemäßen Elektrodeneinheit für die Frequenz 13,56 MHz nahezu homogen und für die Frequenz 40 MHz zumindest stark verbessert ist (Fig. 6B).

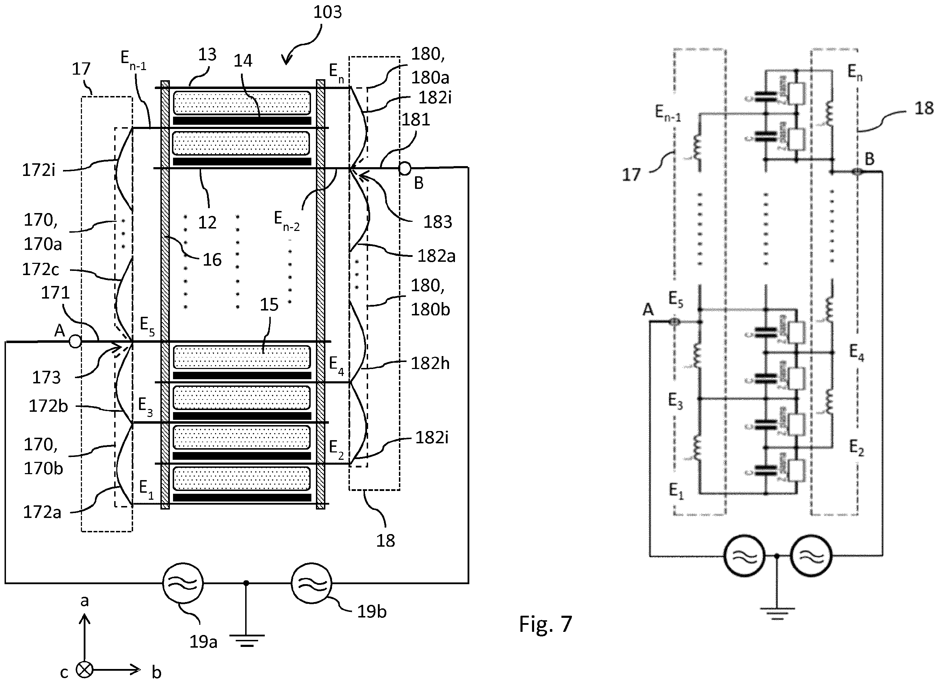

**Figur 7** zeigt eine dritte Ausführungsform 103 der erfindungsgemäßen Elektrodeneinheit sowie deren elektrisches Ersatzschaltbild. Die dritte Ausführungsform 103 unterscheidet sich von der ersten und der zweiten Ausführungsform 101, 102 dadurch, dass der erste Einspeispunkt 173 und der zweite Einspeispunkt 183 frei zwischen der jeweils als Erste und der jeweils als Letzte in der Elektrodeneinheit 103 angeordneten ersten bzw. zweiten Plasmaelektrode 12, 13, die durch das erste bzw. zweite System 170, 180 von Zwischenleitungen 172a-172i, 182a-182i miteinander verbunden sind, angeordnet sind. Das heißt, die Verbindungsleitungen 171, 181 kontaktieren das erste System 170 bzw. das zweite System 180 auf Höhe einer der ersten bzw. zweiten Plasmaelektroden 12, 13, die nicht die Erste oder die Letzte der Plasmaelektroden 12, 13 innerhalb des jeweiligen Systems 170, 180 ist, oder eine der Zwischenleitungen 172a-172i, 182a.182i. In dem in Fig. 7 dargestellten Beispiel liegt der erste Einspeispunkt 173 auf Höhe der dritten ersten Plasmaelektrode 12, d.h. auf Höhe der Elektrode E₅, während der zweite Einspeispunkt 183 auf Höhe der vorletzten zweiten Plasmaelektrode 13, d.h. auf Höhe der Elektrode Eₙ₋₂, liegt.

Damit weisen das erste System 170 und das zweite System 180 jeweils einen ersten Teil 170a, 180a und einen zweiten Teil 170b, 180b auf. Der erste Teil 170a, 180a umfasst jeweils die Zwischenleitungen 172c-172i bzw. 182i, die zwischen der jeweils als Letzte in der Elektrodeneinheit 103 angeordneten ersten bzw. zweiten Plasmaelektrode 12, 13, d.h. zwischen den Elektroden Eₙ₋₁ bzw. Eₙ, und dem jeweiligen Einspeispunkt 173, 183 angeordnet sind. Der zweite Teil 170b, 180b umfasst hingegen die Zwischenleitungen 172a, 172b bzw. 182a-182h, die zwischen der jeweils als Erste in der Elektrodeneinheit 103 angeordneten ersten bzw. zweiten Plasmaelektrode 12, 13, d.h. zwischen den Elektroden E₁ bzw. E₂, und dem jeweiligen Einspeispunkt 173, 183 angeordnet sind. Damit werden die erste eingespeiste Spannung im ersten Teil 170a des ersten Systems 170 und die zweite eingespeiste Spannung m ersten Teil 180a des zweiten Systems 180 in der ersten Richtung und im zweiten Teil 170b des ersten Systems 170 und im zweiten Teil 180b des zweiten Systems 180 in einer zweiten Richtung, die der ersten Richtung entgegengesetzt ist, weitergeleitet.

Wie bereits mit Bezug auf die Figur 5 erwähnt, müssen die Anschlussklemmen A, B nicht an einer bestimmten Position, insbesondere nicht, wie in Fig. 7 gezeigt, an einer Seite der Elektrodeneinheit angeordnet sein, sondern können auch am unteren Ende oder am oberen Ende der Elektrodeneinheit oder beliebig angeordnet sein, wobei dann die Verbindungsleitungen 171, 181 wieder entsprechend geführt und ausgestaltet sind.

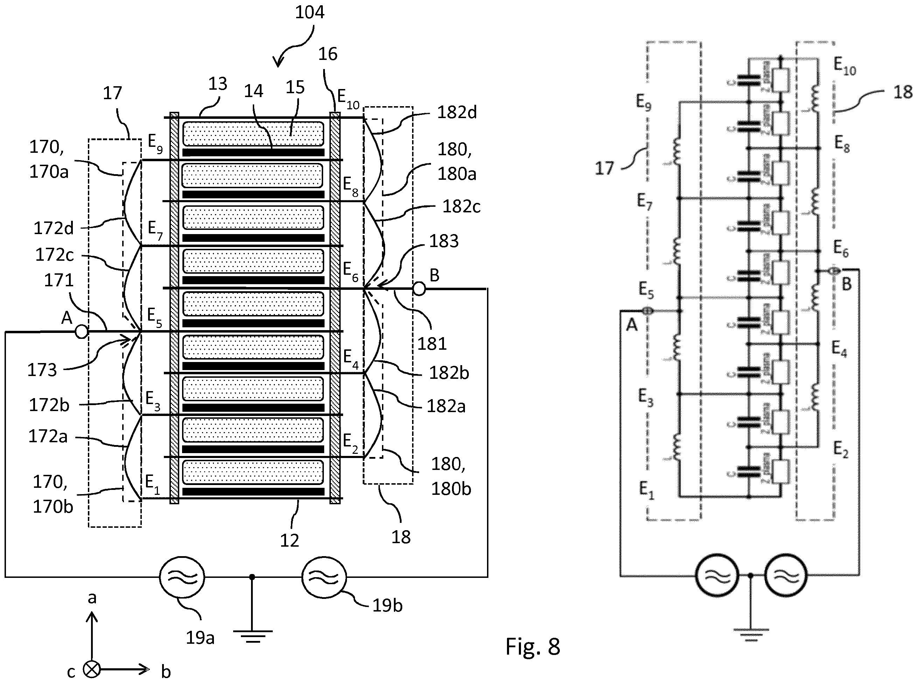

Die in **Figur 8** dargestellte vierte Ausführungsform 104 der erfindungsgemäßen Elektrodeneinheit ist ein Spezialfall der in Fig. 7 dargestellten Ausführungsform und dadurch gekennzeichnet, dass die Einspeispunkte 173, 183 jeweils mittig bezüglich des zugehörigen Systems 170, 180 aus miteinander verbundenen Zwischenleitungen 172a-172d bzw. 182a-182d angeordnet sind. Beispielhaft ist eine Anordnung aus zehn Plasmaelektroden dargestellt. Der erste Einspeispunkt 173 ist auf Höhe der mittleren ersten Plasmaelektrode 12, d.h. auf Höhe der Elektrode E₅, angeordnet, während der zweite Einspeispunkt 183 auf der Höhe der mittleren zweiten Plasmaelektrode 13, d.h. auf Höhe der Elektrode E₆, angeordnet ist. Damit bilden der erste Teil 170a des ersten Systems 170 und der zweite Teil 170b des ersten Systems 170 jeweils eine erste bzw. zweite Hälfte des ersten Systems 170 ab, während der erste Teil 180a des zweiten Systems 180 und der zweite Teil 180b des zweiten Systems 180 jeweils eine erste bzw. zweite Hälfte des zweiten Systems 180 abbilden. Eine eingespeiste erste Spannung bzw. eine eingespeiste zweite Spannung werden damit in der ersten Hälfte 170a des ersten Systems 170 und in der ersten Hälfte 180a des zweiten Systems 180 in der ersten Richtung und in der zweiten Hälfte 170b des ersten Systems 170 und in der zweiten Hälfte 180b des zweiten Systems 180 in einer zweiten Richtung, die der ersten Richtung entgegengesetzt ist, weitergeleitet.

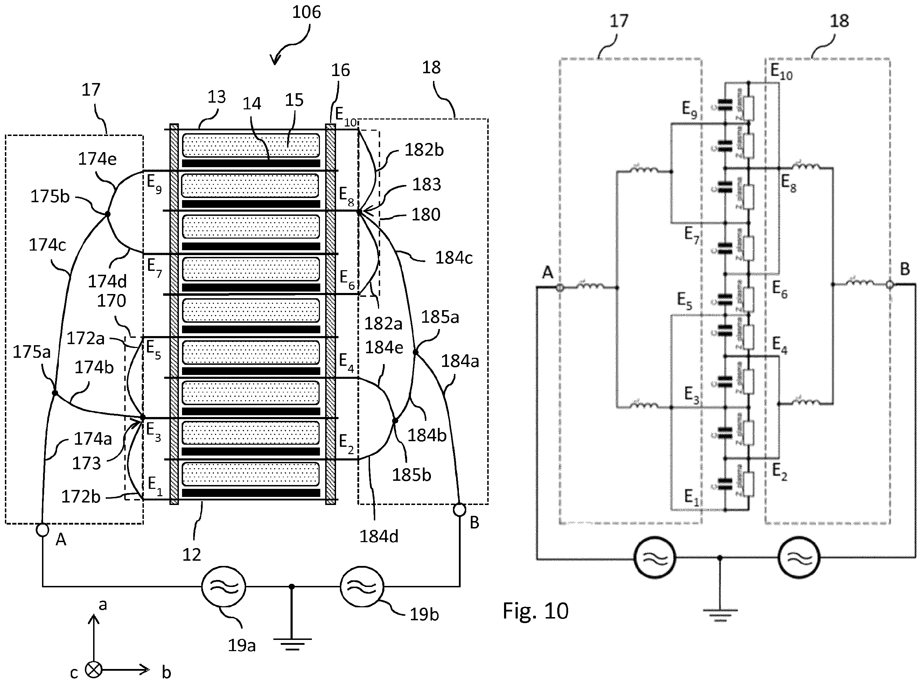

In den in den Figuren 3, 5, 7 und 8 gezeigten Ausführungsbeispielen werden jeweils alle gleichbeschalteten Plasmaelektroden 12, 13 von einem System 170, 180 aus miteinander in Reihe geschalteter Zwischenleitungen 172a-172i, 182a-182i mit Spannung versorgt. Dies ist jedoch nicht notwendig, wie später mit Bezug auf die Figur 10 erläutert wird.

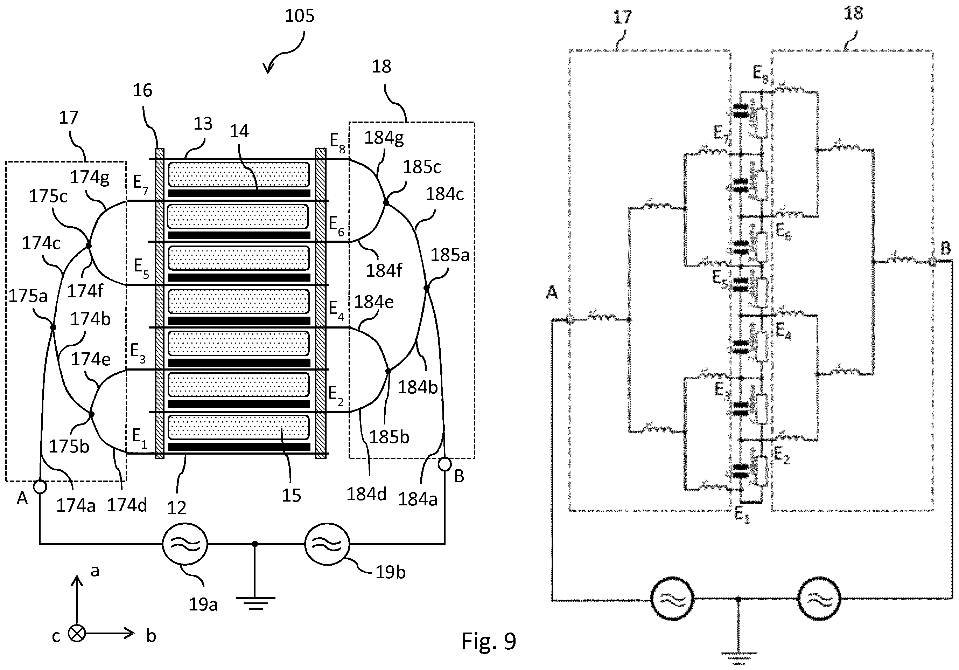

**Figur 9** zeigt eine fünfte Ausführungsform 105 der erfindungsgemäßen Elektrodeneinheit sowie das dazugehörige elektrische Ersatzschaltbild. Hier bestehen das erste und das zweite Zuführungsnetzwerk 17, 18 aus baumförmig angeordneten und binär verzweigten Zuleitungen 174a-174g bzw. 184a-184g. Von der jeweiligen Anschlussklemme A, B verläuft eine erste Zuleitung 174a bzw. eine zweite Zuleitung 184a bis zu einem ersten bzw. zweiten Knotenpunkt (Verzweigungspunkt) 175a, 185a. Von diesem aus verlaufen jeweils zwei weitere erste bzw. zweite Zuleitungen 174b, 174c, 184b, 184c bis zu weiteren ersten bzw. weiteren zweiten Kontenpunkten 175b, 175c, 185b, 185c, wo sich die Zuleitungen nochmals verzweigen. Diese binäre Verzweigung, wobei "binär" dafür steht, dass an jedem Knotenpunkt aus einer hinführenden Zuleitung zwei wegführende Zuleitungen entstehen, wird solange fortgesetzt, bis jede der ersten bzw. zweiten Plasmaelektroden 12, 13 von genau einer separaten Zuleitung kontaktiert wird. In Figur 9 ist dies für vier erste Plasmaelektroden 12 und vier zweite Plasmaelektroden 13 dargestellt. Mit der fünften Ausführungsform lassen sich immer 2ⁿ gleichbeschaltete Plasmaelektroden 12, 13 kontaktieren, wobei n die Anzahl der Knotenebenen ist. Im dargestellten Beispiel werden die ersten Plasmaelektroden 12 durch die ersten Zuleitungen 174d-174g mit einer ersten Spannung versorgt, während die zweiten Plasmaelektroden 13 über die zweiten Zuleitungen 184d-184g mit einer zweiten Spannung versorgt werden. Es gibt in den Zuführungsnetzwerken 17, 18 jeweils zwei Knotenebenen, wobei eine erste Knotenebene die Knotenpunkte 175a bzw. 185a und eine zweite Knotenebene die Knotenpunkte 175b und 175c bzw. 185b und 185c enthält.

Wie dem dazugehörigen elektrischen Ersatzschaltbild (rechte Seite der Fig. 9) zu entnehmen ist, durchläuft damit ein Strom, der während der Plasmabehandlung fließt, auf seinem Weg zwischen der zugehörigen Anschlussklemme A, B und einer der Plasmaelektroden 12, 13 für alle gleichbeschalteten ersten bzw. zweiten Plasmaelektroden 12, 13 dieselbe Anzahl von Leitungsinduktivitäten L und parasitären Kapazitäten. Wenn diese gleichartig ausgestaltet sind, was u.a. über die Abmessungen der als Zuleitungen genutzten Metallstreifen oder Leitungen realisiert werden kann, so ist der Spannungsabfall für alle Plasmaelektrodenpaare der Elektrodeneinheit gleich. Damit wird eine homogene Plasmabehandlung für alle Substrate, die innerhalb der Elektrodeneinheit angeordnet sind, erreicht.

**Figur 10** zeigt eine sechste Ausführungsform 106 der erfindungsgemäßen Elektrodeneinheit, die eine Mischform aus einer baumförmigen und einer reihenförmigen Verschaltung der einzelnen Leitungen ist. Dabei weisen die internen Zuführungsnetzwerke 17, 18 sowohl Zuleitungen 174a-174e, 184a-184e als auch jeweils ein System 170, 180 aus miteinander verbundenen Zwischenleitungen 172a, 172b, 182a, 182b auf. Im dargestellten Beispiel ist eine Elektrodeneinheit mit zehn Plasmaelektroden E₁-E₁₀ gezeigt, wobei von den ersten Plasmaelektroden 12 einige, nämlich die Elektroden E₃, E₇ und Eg, über die Zuleitungen 174a-174e und einige, nämlich die Elektroden E₁ und E₅, über die Zuleitungen 174a und 174b und die Zwischenleitungen 172a, 172b mit Spannung versorgt werden. Der erste Einspeispunkt 173 in das erste System 170 liegt dabei in der Mitte des ersten Systems 170, kann jedoch auch auf Höhe einer beliebigen anderen ersten Plasmaelektrode 2 innerhalb des ersten Systems 170 liegen. Die ersten Zuleitungen 174a und 174b dienen als Verbindungsleitung zwischen der Anschlussklemme A und dem ersten Einspeispunkt 173. Die gleiche Ausgestaltung der Spannungszuführung liegt im zweiten Netzwerk 18 vor, mit dem die zweiten Plasmaelektroden 13 mit Spannung versorgt werden.

Mit einer solchen Mischform kann die Spannungsversorgung einer Elektrodeneinheit mit einer Anzahl von ersten bzw. zweiten Plasmaelektroden 12, 13, die jeweils ungleich einer Potenz von 2 (# 2ⁿ) ist, und die daher nicht durch ein rein baumförmiges Zuführungsnetzwerk von Zuleitungen, wie in Figur 9 dargestellt, mit Spannung versorgt werden kann, realisiert werden.

Darüber hinaus kann ein internes Zuführungsnetzwerk der erfindungsgemäßen Elektrodeneinheit auch mehrere Systeme aus miteinander verbundenen Zwischenleitungen aufweisen, wobei die Verbindungsleitungen zwischen der dazugehörigen Anschlussklemme und den jeweiligen Einspeispunkten in die Systeme jeweils über baumförmig angeordnete und verzweigte Zuleitungen realisiert sind. Damit kann insbesondere bei einer großen Anzahl von Plasmaelektroden die Homogenität der Spannungsverteilung über die gleichbeschalteten Plasmaelektroden der Elektrodeneinheit hinweg weiter verbessert werden.

Vorzugsweise sind die beiden internen Zuführungsnetzwerke 17 und 18, die in den bisher beschriebenen Ausführungsformen der erfindungsgemäßen Elektrodeneinheit vorliegen, gleichartig ausgestaltet. Mit anderen Worten: Die Art der Spannungsverteilung über Zuleitungen und/oder Systeme aus miteinander verbundenen Zwischenleitungen ist für beide Zuführungsnetzwerke gleich.

Selbstverständlich ist die Anzahl der Plasmaelektroden auch in den Ausführungsformen, für die in den Figuren 8 bis 10 eine konkrete Anzahl dargestellt ist, nicht auf diese dargestellte Anzahl begrenzt, sondern kann im Rahmen der für die jeweilige Ausführungsform realisierbaren Anzahl frei gewählt werden.

Mit Bezug auf die **Figuren 11** **und** **12** werden Ausführungsformen der erfindungsgemäßen Elektrodeneinheit beschrieben, die jeweils nur ein internes elektrisches Zuführungsnetzwerk 20 zur Zuführung der Spannung an die Plasmaelektroden 12, 13 der Elektrodeneinheit aufweisen. Dabei ist das Zuführungsnetzwerk 20 jeweils als Hochfrequenzleitung ausgeführt, wobei zwei Systeme 210, 220 aus miteinander verbundenen Zwischenleitungen 212a-212i, 222a-222i räumlich nebeneinander - und nicht wie in den vorherigen Ausführungsformen räumlich voneinander getrennt- angeordnet sind. Dabei ist der Abstand zwischen dem ersten System 210 und dem zweiten System 220 so klein, dass die beiden Systeme 210, 220 kapazitiv und induktiv miteinander gekoppelt sind. Der Abstand liegt vorzugsweise im Bereich von 1 mm bis 50 mm und beträgt bspw. 10 mm. Die Hochfrequenzleitung kann bspw. in Form einer Doppelleitung aus zwei parallelen Drähten oder zwei parallelen Metallstreifen gebildet werden, die jeweils die Zwischenleitungen 212a-212i, 222a-222i und ggf. auch die Verbindungsleitungen 211, 221 realisieren. Vorzugsweise befindet sich zwischen den beiden Drähten oder Metallstreifen nicht nur Luft als Isolator, sondern ein dielektrisches Material, bspw. aus Aluminiumoxidkeramik, Siliziumoxidkeramik o.ä., das die beiden Drähte oder Metallstreifen voneinander isoliert und in der jeweiligen elektrischen Ersatzschaltung als Kapazitäten C_l dargestellt ist. Bei den oben aufgeführten Abmessungen der Metallstreifen für die Zwischenleitungen und einem Abstand von 10 mm zwischen den Metallstreifen der verschiedenen Systeme 210, 220 sowie Aluminiumoxidkeramik als Isolator entsteht so eine Doppelleitung mit einem typischen Wellenwiderstand im Bereich von 10 Ω bis 100 Ω. Durch eine geeignete Dimensionierung der Geometrie der Plasmaelektroden 12, 13 kann weiterhin auch der Lastwiderstand der Plasmaelektroden 12, 13 angepasst werden, wodurch die Spannungszuführung weiter homogenisiert wird. Statt einer Doppelleitung können auch Koaxialkabel zum Einsatz kommen
**Figur 11** zeigt eine siebte Ausführungsform 107 der erfindungsgemäßen Elektrodeneinheit mit einem internen Zuführungsnetzwerk 20, bei dem die Einspeispunkte 213, 223 beider Systeme 210, 220 jeweils auf der Höhe der als Erste entlang der ersten Richtung in der Elektrodeneinheit angeordneten ersten bzw. zweiten Plasmaelektrode 12, 13 (E₁ bzw. E₂) angeordnet sind. Mit anderen Worten: Die Einspeispunkte 213, 223 befinden sich auf derselben Seite der Elektrodeneinheit mit Bezug auf die erste Richtung. Damit wird die Hochfrequenzleitung des Zuführungsnetzwerkes 20 von einem während einer Plasmabehandlung fließenden Hochfrequenzstrom in einem der Systeme 210, 220 hin und im anderen System 210, 220 zurück durchflossen, d.h. der resultierende Strom fließt im ersten System 210 und im zweiten System 220 in entgegengesetzter Richtung. In jedem Element der beiden Systeme 210, 220, d.h. in jeder der Zwischenleitungen 212a-212i, 222a-222i ist damit der "Hinstrom" gleich dem "Rückstrom", wodurch die Spannungsabfälle an den parasitären Leitungsinduktivitäten L weiter reduziert werden.

**Figur 12** zeigt eine achte Ausführungsform 108 der erfindungsgemäßen Elektrodeneinheit, bei der sich im Gegensatz zu der siebten Ausführungsform 107 die Einspeispunkte 213, 223 an den entgegengesetzten Seiten der jeweiligen Systeme 210, 220 mit Bezug auf die erste Richtung befinden. Damit befindet sich bspw. der erste Einspeispunkt 213 in das erste System 210 auf Höhe der als Erste entlang der ersten Richtung in der Elektrodeneinheit angeordneten ersten Plasmaelektrode 12 (E₁), während sich der zweite Einspeispunkt 223 in das zweite System 220 auf Höhe der als Letzte entlang der ersten Richtung in der Elektrodeneinheit angeordneten zweiten Plasmaelektrode 13 (Eₙ) befindet. Damit entsteht in den parallelen Leitern der Systeme 210, 220 im Falle einer Plasmabehandlung kein hin- und zurücklaufender Hochfrequenzstrom, sondern ein Hochfrequenzstromfluss in die gleiche Richtung in beiden Systemen 210, 220. Auch dies führt zu einer Homogenisierung der Spannungsverteilung.

Mit Bezug auf **Figur 13** wird eine weitere Ausgestaltung der erfindungsgemäßen Elektrodeneinheit erläutert. Figur 13 zeigt eine neunte Ausführungsform 109, bei der die Elektrodeneinheit zwei räumlich voneinander getrennte Zuführungsnetzwerke 17, 18 aufweist, die - ähnlich wie mit Bezug auf die in Figur 3 dargestellte erste Ausführungsform erläutert - ausgestaltet sind. Um ggf. noch vorhandene Spannungsunterschiede für gleichbeschaltete Plasmaelektroden 12, 13 weiter zu reduzieren, ist auf den Plasmaelektroden 12, 13 jeweils auf der dem Plasmaraum 15 zugewandten Oberfläche der Plasmaelektrode 12, 13 eine dielektrische Schicht 30 angeordnet. Diese wirkt als zusätzlicher Kondensator für das jeweilige Plasmaelektrodenpaar. Um die Plasmaerzeugungsbedingungen zwischen den Plasmaräumen 15 der Elektrodeneinheit zu homogenisieren, kann die dielektrische Schicht 30 in ihren Eigenschaften, insbesondere in der Dicke der Schicht, aber ggf. auch im Material der Schicht, auf das jeweilige Plasmaelektrodenpaar angepasst werden. Die dielektrische Schicht 30 besteht vorzugsweise aus einem der Materialien wie Aluminiumoxid, Siliziumoxid, Zirkonoxid oder aus Kombinationen oder Schichtaufbauten daraus und weist vorzugsweise ein Dicke im Bereich von 1 µm bis 1000 µm auf. Die Dicke der Schicht kann über die gesamte Ausdehnung der jeweiligen Plasmaelektrode 12, 13 hinweg gleich oder verschieden, bspw. in einem zentralen Bereich der Plasmaelektrode 12, 13 dicker als an den Rändern der Plasmaelektrode 12, 13, sein.

Selbstverständlich kann die dielektrische Schicht auch auf der dem Substrat 14 zugewandten Oberfläche der jeweiligen Plasmaelektrode 12, 13 oder auf beiden Oberflächen der Plasmaelektroden 12, 13 ausgebildet sein. Darüber hinaus kann die dielektrische Schicht nicht auf allen, sondern nur auf mindestens einer oder auf ausgewählten Plasmaelektroden 12, 13 angeordnet sein. Weiterhin können die Zuführungsnetzwerke 17, 18 beliebig entsprechend der oben beschriebenen Ausführungsformen ausgestaltet oder nur ein internes elektrisches Zuführungsnetzwerk entsprechend der Figuren 11 und 12 vorhanden sein.

Die in den Figuren 3, 5 und 7 bis 13 dargestellten Hochfrequenz-Spannungsgeneratoren 19a und 19b sind jeweils eine Kombination aus einem Hochfrequenzgenerator und einem externen Anpassungsnetzwerk, wie dies mit Bezug auf Fig. 2 erläutert wurde. Mit Hilfe der externen Anpassungsnetzwerke kann durch eine geeignete Einstellung oder Auswahl der enthaltenen elektrischen Bauteile die rücklaufende Hochfrequenzleistung an den Anschlussklemmen A, B auf ein Minimum eingestellt werden. Darüber hinaus ist die in allen Figuren dargestellte symmetrische Spannungszuführung nur eine bevorzugte Ausführungsform. Auch eine asymmetrische Beschaltung der ersten und zweiten Plasmaelektroden ist möglich.

Für alle bisher dargestellten Ausführungsformen gilt, dass das mindestens eine interne elektrische Zuführungsnetzwerk neben den Zuleitungen und/oder Zwischenleitungen und/oder Verbindungsleitungen weitere passive elektrische Bauteile enthalten kann. Dies können zusätzliche Induktivitäten oder Kapazitäten sein, die der weiteren Homogenisierung der Spannungsverteilung über die Elektrodeneinheit hinweg dienen.

Das mindestens eine interne elektrische Zuführungsnetzwerk kann auch als Leiterplatte mit integrierten elektrischen Leitungen und integrierten passiven elektrischen Bauteilen ausgebildet sein.

Einige oder alle der genannten Möglichkeiten zur Verbesserung der Homogenität der Spannungsverteilung bei gleichbeschalteten Plasmaelektroden einer Elektrodeneinheit und der beschriebenen Ausführungsformen können auch miteinander kombiniert werden, solange sie sich nicht gegenseitig ausschließen.

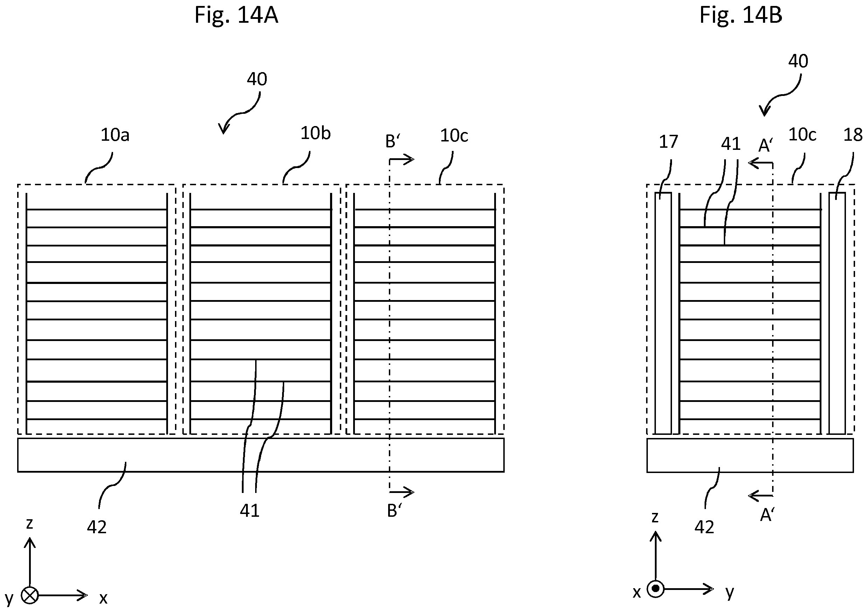

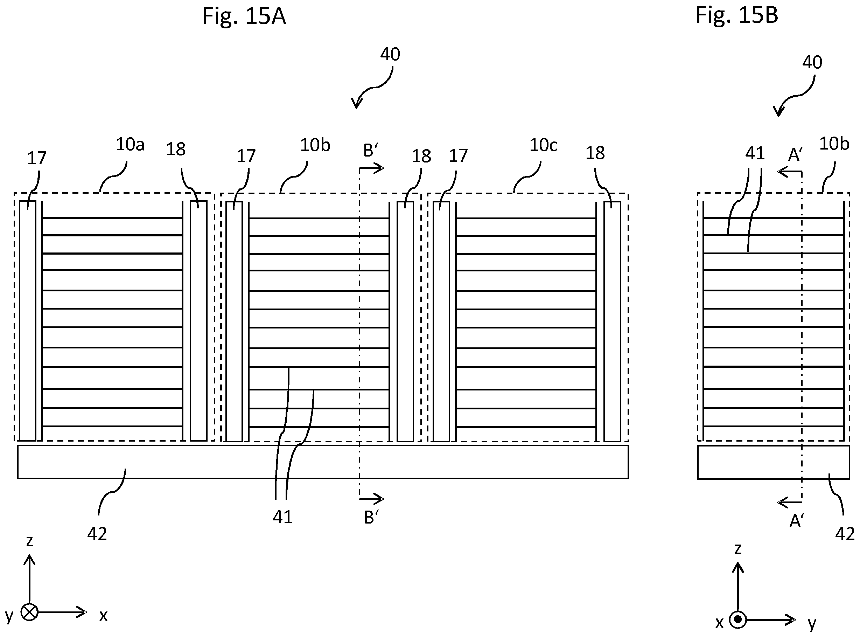

Mit Bezug auf die **Figuren 14A bis 15B** wird eine erfindungsgemäße Trägeranordnung 40 näher erläutert. Dabei zeigen die Figuren 14A und 15A jeweils schematische Querschnitte durch die Trägeranordnung 40 entlang einer dritten Richtung (x-Achse), d.h. entlang einer Linie A'-A', und die Figuren 14B und 15B schematische Querschnitte durch die Trägeranordnung 40 entlang einer vierten Richtung (y-Achse), d.h. entlang einer Linie B'-B'. Die dritte und die vierte Richtung sind zwei Richtungen eines kartesischen Koordinatensystems (x, y, z), das mit Bezug auf die Trägeranordnung 40 definiert und von dem kartesischen Koordinatensystem (a, b, c), das mit Bezug auf die Elektrodeneinheit definiert und in den Figuren 1 bis 13 dargestellt ist, unabhängig ist.

Die Trägeranordnung 40 weist jeweils mindestens zwei, innerhalb der Trägeranordnung 40 ortsfest nebeneinander entlang der dritten Richtung angeordnete erfindungsgemäße Elektrodeneinheiten auf. In den Figuren 14A und 15A sind jeweils drei derartige Elektrodeneinheiten 10a-10c schematisch dargestellt. Jede Elektrodeneinheit 10a-10c weist Plasmaelektroden 41 sowie mindestens ein internes elektrisches Zuführungsnetzwerk, in den dargestellten Beispielen jeweils zwei Zuführungsnetzwerke 17, 18, auf. Die Trägeranordnung 40 enthält darüber hinaus eine Anschlusseinheit 42, die den elektrischen Anschluss der verschiedenen Elektrodeneinheiten 10a-10c an einen außerhalb einer Behandlungskammer angeordneten Hochfrequenz-Spannungsgenerator realisiert. Die Anschlusseinheit 42 trägt und fixiert die verschiedenen Elektrodeneinheiten 10a-10c und gewährleistet damit die mechanische Stabilität und den physischen Zusammenhalt der verschiedenen Elektrodeneinheiten 10a-10c der Trägeranordnung 40. Weiterhin gewährleistet sie die elektrische Kontaktierung der Zuführungsnetzwerke 17, 18 der Elektrodeneinheiten 10a-10c. Vorzugsweise ist die Trägeranordnung 40 in die Behandlungskammer einer Plasmabehandlungsanlage ein- und ausfahrbar, wobei die Trägeranordnung 40 während der Plasmabehandlung selbst ortsfest oder beweglich in der Behandlungskammer angeordnet ist. Die mit Bezug auf die Trägeranordnung 40 definierte dritte Richtung (x-Achse) ist bspw. die Richtung, entlang der die Trägeranordnung 40 in die Behandlungskammer ein- und ausgefahren wird.

Gemäß einer ersten Ausführungsform der erfindungsgemäßen Trägeranordnung 40, die in den Figuren 14A und 14B dargestellt ist, ist mindestens eines der Zuführungsnetzwerke 17, 18 der Elektrodeneinheiten 10a-10c entlang einer Seite der betreffenden Elektrodeneinheit 10a-10c angeordnet, die nicht an eine andere Elektrodeneinheit 10a-10c angrenzt. Für das in Fig. 14A und 14B gezeigte Beispiel sind die Zuführungsnetzwerke 17, 18 aller Elektrodeneinheiten 10a-10c auf den beiden Seiten der jeweiligen Elektrodeneinheit 10a-10c, die sich entlang der dritten Richtung (x-Achse) erstrecken, angeordnet.

Gemäß einer zweiten Ausführungsform der erfindungsgemäßen Trägeranordnung 40, die in den Figuren 15A und 15B dargestellt ist, ist mindestens eines der Zuführungsnetzwerke 17, 18 der Elektrodeneinheiten 10a-10c entlang einer Seite der betreffenden Elektrodeneinheit 10a-10c angeordnet, die an eine andere Elektrodeneinheit 10a-10c angrenzt. Für das in Fig. 15A und 15B gezeigte Beispiel sind alle Zuführungsnetzwerke 17, 18 auf den beiden Seiten der jeweiligen Elektrodeneinheit 10a-10c, die sich entlang der vierten Richtung (y-Achse) erstrecken, angeordnet, so dass zumindest die Zuführungsnetzwerke 17, 18 der mittleren Elektrodeneinheit 10b zwischen den Plasmaelektroden 41 der Elektrodeneinheiten 10a und 10b bzw. 10b und 10c angeordnet sind.

Vorzugsweise sind die Zuführungsnetzwerke aller Elektrodeneinheiten der Trägeranordnung gleichartig angeordnet, wie dies in den Figuren 14A bis 15B dargestellt ist. Jedoch kann auch mindestens ein Zuführungsnetzwerk mindestens einer Elektrodeneinheit der Trägeranordnung andersartig angeordnet sein, wenn dies für die Plasmabehandlung der Substrate oder andere Eigenschaften der Trägeranordnung vorteilhaft ist.

Darüber hinaus kann die Trägeranordnung neben Elektrodeneinheiten, die entlang der dritten Richtung (x-Achse) nebeneinander angeordnet sind (wie dies in den Figuren 14A bis 15B dargestellt ist), auch Elektrodeneinheiten, die entlang der vierten Richtung (y-Achse) oder entlang einer fünften Richtung (z-Achse) nebeneinander angeordnet sind, enthalten.

### Bezugszeichen

- 1: Elektrodeneinheit nach dem Stand der Technik
- 2: Erste Plasmaelektrode
- 3: Zweite Plasmaelektrode
- 4: Substrat
- 5: Plasmaraum
- 6: Isolierender Träger
- 7: Erste Verteilleitung
- 8: Zweite Verteilleitung
- 9: Niederfrequenz-Spannungsgenerator
- 10, 10a-10c, 101-109: Erfindungsgemäße Elektrodeneinheit
- 12: Erste Plasmaelektrode
- 13: Zweite Plasmaelektrode
- 14: Substrat
- 15: Plasmaraum
- 16: Isolierender Träger
- 17: Erstes Zuführungsnetzwerk
- 18: Zweites Zuführungsnetzwerk
- 19a, 19b: Hochfrequenz-Spannungsgenerator
- 20: Zuführungsnetzwerk
- 30: Dielektrische Schicht
- 40: Trägeranordnung
- 41: Plasmaelektrode
- 42: Anschlusseinheit
- 170: Erstes System
- 170a: Erster Teil des ersten Systems
- 170b: Zweiter Teil des ersten Systems
- 171: Erste Verbindungsleitung
- 172a-172i: Erste Zwischenleitung
- 173: Erster Einspeispunkt
- 174a-174g: Erste Zuleitung
- 175a-175c: Erster Knotenpunkt
- 180: Zweites System
- 180a: Erster Teil des zweiten Systems
- 180b: Zweiter Teil des zweiten Systems
- 181: Zweite Verbindungsleitung
- 182a-182i: Zweite Zwischenleitung
- 183: Zweiter Einspeispunkt
- 184a-184g: Zweite Zuleitung
- 185a-185c: Zweiter Knotenpunkt
- 190a, 190b: Externes Anpassungsnetzwerk
- 210: Erstes System
- 211: Erste Verbindungsleitung
- 212a-212i: Erste Zwischenleitung
- 213: Erster Einspeispunkt
- 220: Zweites System
- 221: Zweite Verbindungsleitung
- 222a-222i: Zweite Zwischenleitung
- 223: Zweiter Einspeispunkt

- A: Erste Anschlussklemme
- B: Zweite Anschlussklemme

## Patentansprüche

1. Elektrodeneinheit (10, 101... 109), geeignet zur Plasmabehandlung einer Mehrzahl von Substraten (14) in einer Behandlungskammer einer Plasmabehandlungsanlage, mit
- mehreren Plasmaelektrodenpaaren entlang einer ersten Richtung, wobei jedes Plasmaelektrodenpaar aus einer ersten Plasmaelektrode (12) und einer zweiten Plasmaelektrode (13) besteht, die parallel zueinander und einander gegenüberliegend angeordnet und elektrisch voneinander isoliert sind, und geeignet ist, bei Vorliegen einer definierten Spannung ein Plasma in einem Plasmaraum (15) zwischen der ersten und der zweiten Plasmaelektrode (12, 13) des Plasmaelektrodenpaares zu zünden,
- mindestens einem internen elektrischen Zuführungsnetzwerk (17, 18, 20), das geeignet ist, innerhalb der Behandlungskammer eine erste Spannung jeder ersten Plasmaelektrode (12) der Elektrodeneinheit (10, 101...109) und eine zweite Spannung jeder zweiten Plasmaelektrode (13) der Elektrodeneinheit (10, 101... 109) zuzuführen, wobei mindestens eine der Spannungen eine Spannung mit einer Frequenz im Bereich von 1 MHz bis 100 MHz ist,
- eine erste Anschlussklemme (A) und eine zweite Anschlussklemme (B), die geeignet sind, die erste Spannung über die erste Anschlussklemme (A) und die zweite Spannung über die zweite Anschlussklemme (B) in das mindestens eine interne elektrische Zuführungsnetzwerk (17, 18, 20) einzuspeisen,
**dadurch gekennzeichnet, dass** das mindestens eine interne elektrische Zuführungsnetzwerk (17, 18, 20) entsprechend der Anordnung der Plasmaelektroden (12, 13) in der Elektrodeneinheit (10, 101... 109) und der Frequenz der ersten Spannung und/oder der zweiten Spannung ausgelegt ist, wobei das mindestens eine interne elektrische Zuführungsnetzwerk (17, 18, 20) Zuleitungen (174a-g, 184a-g) zwischen der ersten bzw. der zweiten Anschlussklemme (A, B) und mindestens zwei ersten bzw. mindestens zwei zweiten Plasmaelektroden (12, 13) und/oder Zwischenleitungen (172a-i, 182a-i, 212a-212i, 222a-222i) zwischen zwei benachbarten ersten bzw. zweiten Plasmaelektroden (2, 3) und jeweils einen Einspeispunkt (173, 183, 213, 223) in ein erstes bzw. zweites System (170, 180, 210, 220) aus miteinander verbundenen Zwischenleitungen (172a-172i, 182a-182i, 212a-i, 222a-i) und jeweils eine Verbindungsleitung (171, 181, 211, 221) zwischen der ersten bzw. der zweiten Anschlussklemme (A, B) und dem zugehörigen Einspeispunkt (173, 183, 213, 223) aufweist und die Auslegung des Netzwerkes in einer geeigneten Anordnung der Zuleitungen (174a-g, 184a-g) und/oder in geeigneten geometrischen Abmessungen der Zuleitungen (174a-g, 184a-g) und/oder der Zwischenleitungen (172a-i, 182a-i, 212a-212i, 222a-222i) und/oder der Verbindungsleitungen (171, 181, 211, 221) und/oder in einem geeigneten Material der Zuleitungen (174a-g, 184a-g) und/oder der Zwischenleitungen (172a-i, 182a-i, 212a-i, 222a-i) und/oder der Verbindungsleitungen (171, 181, 211, 221) und/oder in einer geeigneten Anordnung des Einspeispunktes (173, 183, 213, 223) in Bezug auf die Elektrodeneinheit (10, 101... 109) entlang der ersten Richtung besteht.

2. Elektrodeneinheit nach Anspruch 1, **dadurch gekennzeichnet, dass** die Zuleitungen (174a-g, 184a-g) und/oder die Zwischenleitungen (172a-i, 182a-i, 212a-i, 222a-i) und/oder die Verbindungsleitungen (171, 181, 211, 221)jeweils Metallstreifen mit einer Dicke im Bereich von 0,1 mm bis 5 mm und einer Breite im Bereich von 1 mm bis 100 mmm sind.

3. Elektrodeneinheit nach Anspruch 1 oder 2, **dadurch gekennzeichnet, dass** die Zuleitungen (174a-g, 184a-g) und/oder die Zwischenleitungen (172a-i, 182a-i, 212a-i, 222a-i) und/oder die Verbindungsleitungen (171, 181, 211, 221) jeweils Metallstreifen aus einem hochleitfähigen Material aus der Gruppe umfassend Aluminium, Kupfer Silber und versilbertes Kupfer sind.

4. Elektrodeneinheit (101) nach einem der vorherigen Ansprüche, **dadurch gekennzeichnet, dass** die Elektrodeneinheit ein erstes internes elektrisches Zuführungsnetzwerk (17), das geeignet ist, innerhalb der Behandlungskammer die erste Spannung jeder ersten Plasmaelektrode (12) der Elektrodeneinheit zuzuführen, und ein zweites internes elektrisches Zuführungsnetzwerk (18), das geeignet ist, innerhalb der Behandlungskammer die zweite Spannung jeder zweiten Plasmaelektrode (13) der Elektrodeneinheit zuzuführen, aufweist, wobei das erste Zuführungsnetzwerk (17) und das zweite Zuführungsnetzwerk (18) räumlich voneinander getrennt sind, der Einspeispunkt (173) des ersten Zuführungsnetzwerkes (17) auf Höhe einer ersten Plasmaelektrode (12), die entlang der ersten Richtung als Erste in einer Gruppe untereinander durch das erste System (170) von Zwischenleitungen (172a-i) verbundener erster Plasmaelektroden (12) angeordnet ist, und der Einspeispunkt (183) des zweiten Zuführungsnetzwerkes (18) auf Höhe einer zweiten Plasmaelektrode (13), die entlang der ersten Richtung als Erste in einer Gruppe untereinander durch das zweite System (180) von Zwischenleitungen (182a-i)verbundener zweiter Plasmaelektroden (13) angeordnet ist, angeordnet sind, so dass die eingespeiste erste oder zweite Spannung im ersten und im zweiten System (170, 180) in gleicher Richtung weitergeleitet wird.

5. Elektrodeneinheit (102) nach einem der Ansprüche 1 bis 4, **dadurch gekennzeichnet, dass** die Elektrodeneinheit ein erstes internes elektrisches Zuführungsnetzwerk (17), das geeignet ist, innerhalb der Behandlungskammer die erste Spannung jeder ersten Plasmaelektrode (12) der Elektrodeneinheit zuzuführen, und ein zweites internes elektrisches Zuführungsnetzwerk (18), das geeignet ist, innerhalb der Behandlungskammer die zweite Spannung jeder zweiten Plasmaelektrode (13) der Elektrodeneinheit zuzuführen, aufweist, wobei das erste Zuführungsnetzwerk (17) und das zweite Zuführungsnetzwerk (18) räumlich voneinander getrennt sind, der Einspeispunkt (173) des ersten Zuführungsnetzwerkes (17) auf Höhe einer ersten Plasmaelektrode (12), die entlang der ersten Richtung als Erste in einer Gruppe untereinander durch das erste System (170) von Zwischenleitungen (172a-i)verbundener erster Plasmaelektroden (12) angeordnet ist, und der Einspeispunkt (183) des zweiten Zuführungsnetzwerkes (18) auf Höhe einer zweiten Plasmaelektrode (13), die entlang der ersten Richtung als Letzte in einer Gruppe untereinander durch das zweite System (180) von Zwischenleitungen (182a-i) verbundener zweiter Plasmaelektroden (13) angeordnet ist, angeordnet sind, so dass die eingespeiste erste oder zweite Spannung im ersten und im zweiten System (170, 180) in entgegengesetzter Richtung weitergeleitet wird.

6. Elektrodeneinheit (103) nach einem der Ansprüche 1 bis 4, **dadurch gekennzeichnet, dass** die Elektrodeneinheit ein erstes internes elektrisches Zuführungsnetzwerk (17), das geeignet ist, innerhalb der Behandlungskammer die erste Spannung jeder ersten Plasmaelektrode (12) der Elektrodeneinheit zuzuführen, und ein zweites internes elektrisches Zuführungsnetzwerk (18), das geeignet ist, innerhalb der Behandlungskammer die zweite Spannung jeder zweiten Plasmaelektrode (13) der Elektrodeneinheit zuzuführen, aufweist, wobei das erste Zuführungsnetzwerk (17) und das zweite Zuführungsnetzwerk (18) räumlich voneinander getrennt sind, der Einspeispunkt (173) des ersten Zuführungsnetzwerkes (17) zwischen einer ersten Plasmaelektrode (12), die entlang der ersten Richtung als Erste in einer Gruppe untereinander durch das erste System (170) von Zwischenleitungen (172a-i) verbundener erster Plasmaelektroden (12) angeordnet ist, und einer anderen ersten Plasmaelektrode (12), die entlang der ersten Richtung als Letzte in der Gruppe untereinander durch das erste System (170) von Zwischenleitungen (172a-i) verbundener erster Plasmaelektroden (12) angeordnet ist, und der Einspeispunkt (183) des zweiten Zuführungsnetzwerkes (18) zwischen einer zweiten Plasmaelektrode (13), die entlang der ersten Richtung als Erste in einer Gruppe untereinander durch das zweite System (180) von Zwischenleitungen (182a-i) verbundener zweiter Plasmaelektroden (13) angeordnet ist, und einer anderen zweiten Plasmaelektrode (13), die entlang der ersten Richtung als Letzte in der Gruppe untereinander durch das zweite System (180) von Zwischenleitungen (182a-i)verbundener zweiter Plasmaelektroden (13) angeordnet ist, angeordnet sind, so dass die eingespeiste erste oder zweite Spannung in einem ersten Teil (170a) des ersten Systems (170) und in einem ersten Teil (180a) des zweiten Systems (180) in der ersten Richtung und in einem zweiten Teil (170b) des ersten Systems (170) und in einem zweiten Teil (180b) des zweiten Systems (180) in einer zweiten Richtung, die der ersten Richtung entgegengesetzt ist, weitergeleitet wird.

7. Elektrodeneinheit (104) nach Anspruch 6, **dadurch gekennzeichnet, dass** der Einspeispunkt (173) des ersten Zuführungsnetzwerkes (17) entlang der ersten Richtung mittig im ersten System (170) aus miteinander verbundenen Zwischenleitungen (172a-i) und der Einspeispunkt (183) des zweiten Zuführungsnetzwerkes (18) entlang der ersten Richtung mittig im zweiten System (180) aus miteinander verbundenen Zwischenleitungen (182a-i) angeordnet sind, so dass die eingespeiste erste oder zweite Spannung in einer ersten Hälfte (170a) des ersten Systems (170) und in einer ersten Hälfte (180a) des zweiten Systems (170) in der ersten Richtung und in einer zweiten Hälfte (170b) des ersten Systems (170) und in einer zweiten Hälfte (180b) des zweiten Systems (180) in einer zweiten Richtung, die der ersten Richtung entgegengesetzt ist, weitergeleitet wird.

8. Elektrodeneinheit (101... 104) nach einem der Ansprüche 1 bis 7, **dadurch gekennzeichnet, dass** alle ersten Plasmaelektroden (12) der Elektrodeneinheit durch das erste System (170) und alle zweiten Plasmaelektroden (13) durch das zweite System (180) mit Spannung versorgt werden.

9. Elektrodeneinheit (106) nach einem der Ansprüche 1 bis 7, **dadurch gekennzeichnet, dass** die Elektrodeneinheit ein erstes internes elektrisches Zuführungsnetzwerk (17), das geeignet ist, innerhalb der Behandlungskammer die erste Spannung jeder ersten Plasmaelektrode (12) der Elektrodeneinheit zuzuführen, und ein zweites internes elektrisches Zuführungsnetzwerk (18), das geeignet ist, innerhalb der Behandlungskammer die zweite Spannung jeder zweiten Plasmaelektrode (13) der Elektrodeneinheit zuzuführen, aufweist, wobei das erste Zuführungsnetzwerk (17) und das zweite Zuführungsnetzwerk (18) räumlich voneinander getrennt sind, jedes Zuführungsnetzwerk (17, 18) Zuleitungen (174a, 174c-e, 184a, 184c-e) zwischen der ersten bzw. der zweiten Anschlussklemme (A, B) und mindestens zwei ersten bzw. mindestens zwei zweiten Plasmaelektroden (12, 13) und mindestens eine Zuleitung (174a, 174b, 184a, 184b) zu mindestens einem System (170, 180) aus miteinander verbundenen Zwischenleitungen (172a, 172b, 182a, 182b) aufweist, wobei sich die Zuleitungen (174a-g, 184a-g) ausgehend von einer Zuleitung (174a, 184a), die mit der ersten bzw. zweiten Anschlussklemme (A, B) verbunden ist, baumförmig jeweils binär in zwei weitere Zuleitungen (174b-e, 184b-e) aufteilen, bis jede der mindestens zwei ersten bzw. mindestens zwei zweiten Plasmaelektroden (12, 13) und das mindestens eine System (170, 180) aus miteinander verbundenen Zwischenleitungen (172a, 172b, 182a, 182b) über eine separate Zuleitung (174b, 174d, 174e, 184b, 184d, 184e) kontaktiert ist.

10. Elektrodeneinheit (105) nach einem der Ansprüche 1 bis 4, **dadurch gekennzeichnet, dass** die Elektrodeneinheit ein erstes internes elektrisches Zuführungsnetzwerk (17), das geeignet ist, innerhalb der Behandlungskammer die erste Spannung jeder ersten Plasmaelektrode (12) der Elektrodeneinheit zuzuführen, und ein zweites internes elektrisches Zuführungsnetzwerk (18), das geeignet ist, innerhalb der Behandlungskammer die zweite Spannung jeder zweiten Plasmaelektrode (13) der Elektrodeneinheit zuzuführen, aufweist, wobei das erste Zuführungsnetzwerk (17) und das zweite Zuführungsnetzwerk (18) räumlich voneinander getrennt sind, jedes Zuführungsnetzwerk (17, 18) Zuleitungen (174a-g, 184a-g) zwischen der ersten bzw. der zweiten Anschlussklemme (A, B) und jeder ersten bzw. zweiten Plasmaelektrode (12, 13) aufweist, wobei sich die Zuleitungen (174a-g, 184a-g) ausgehend von einer Zuleitung (174a, 184a), die mit der ersten bzw. zweiten Anschlussklemme (A, B) verbunden ist, baumförmig jeweils binär in zwei weitere Zuleitungen (174b-g, 184b-g) aufteilen, bis jede erste bzw. zweite Plasmaelektrode (12, 13) über eine separate Zuleitung (174d-g, 184d-g) kontaktiert ist.

11. Elektrodeneinheit (107) nach einem der Ansprüche 1 bis 4, **dadurch gekennzeichnet, dass** die Elektrodeneinheit nur ein internes elektrisches Zuführungsnetzwerk (20) aufweist, in dem das erste System (210) aus miteinander verbundenen Zwischenleitungen (212a-i), das alle ersten Plasmaelektroden (12) miteinander verbindet, und das zweite System (220) aus miteinander verbundenen Zwischenleitungen (222a-i), das alle zweiten Plasmaelektroden (13) miteinander verbindet, räumlich nebeneinander mit einem Abstand, derso klein ist, dass eine kapazitive und induktive Kopplung zwischen dem ersten System (210) und dem zweiten System (220) vorhanden und nicht vernachlässigbar ist, angeordnet und durch einen Isolator voneinander getrennt sind, das erste System (210) und das zweite System (220) als eine Hochfrequenzleitung ausgeführt ist, der Einspeispunkt (213) des ersten Systems (210) auf Höhe einer ersten Plasmaelektrode (12), die entlang der ersten Richtung als Erste in einer Gruppe von untereinander durch das erste System (210) verbundener erster Plasmaelektroden (12) angeordnet ist, und der Einspeispunkt (223) des zweiten Systems (220) auf Höhe einer zweiten Plasmaelektrode (13), die entlang der ersten Richtung als Erste in einer Gruppe von untereinander durch das zweites System (220) verbundener zweiter Plasmaelektroden (13) angeordnet ist, angeordnet sind, so dass während einer Plasmabehandlung ein resultierender Strom im ersten System (210) und im zweiten System (220) in entgegengesetzter Richtung fließt.

12. Elektrodeneinheit (108) nach einem der Ansprüche 1 bis 4, **dadurch gekennzeichnet, dass** die Elektrodeneinheit nur ein internes elektrisches Zuführungsnetzwerk (20) aufweist, in dem das erste System (210) aus miteinander verbundenen Zwischenleitungen (212a-i), das alle ersten Plasmaelektroden (12) miteinander verbindet, und ein zweites System (220) aus miteinander verbundenen Zwischenleitungen (222a-i), das alle zweiten Plasmaelektroden (13) miteinander verbindet, räumlich nebeneinander mit einem Abstand, der so klein ist, dass eine kapazitive und induktive Kopplung zwischen dem ersten System (210) und dem zweiten System (220) vorhanden und nicht vernachlässigbar ist, angeordnet und durch einen Isolator voneinander getrennt sind, das erste System (210) und das zweite System (220) als eine Hochfrequenzleitung ausgeführt ist, der Einspeispunkt (213) des ersten Systems (210) auf Höhe einer ersten Plasmaelektrode (12), die entlang der ersten Richtung als Erste in einer Gruppe von untereinander durch das erste System (210) verbundener erster Plasmaelektroden (12) angeordnet ist, und der Einspeispunkt (223) des zweiten Systems (220) auf Höhe einer zweiten Plasmaelektrode (13), die entlang der ersten Richtung als Letzte in einer Gruppe von untereinander durch das zweites System (220) verbundener zweiter Plasmaelektroden (13) angeordnet ist, angeordnet sind, so dass während einer Plasmabehandlung ein resultierender Strom im ersten System (210) und im zweiten System (220) in gleicher Richtung fließt.

13. Elektrodeneinheit (109) nach einem der vorherigen Ansprüche, **dadurch gekennzeichnet, dass** mindestens eine erste oder mindestens eine zweite Plasmaelektrode (12, 13) auf einer Seite, die einem zu dieser Plasmaelektrode (12, 13) zugehörigen Plasmaraum (15) zugewandt ist, und/oder auf einer Seite, die einem auf dieser Plasmaelektrode (12, 13) aufliegenden Substrat (14) zugewandt ist, eine dielektrische Schicht (30) aufweist.

14. Elektrodeneinheit nach einem der vorherigen Ansprüche, **dadurch gekennzeichnet, dass** das mindestens eine interne elektrische Zuführungsnetzwerk (17, 18, 20) neben den Zuleitungen (174a-g, 184a-g) und/oder Zwischenleitungen (172a-i, 182a-i, 212a-i, 222a-i) und/oder der Verbindungsleitungen (171, 181, 211, 221)passive elektrische Bauteile enthält.

15. Elektrodeneinheit nach einem der vorherigen Ansprüche, **dadurch gekennzeichnet, dass** das mindestens eine interne elektrische Zuführungsnetzwerk (17, 18, 20) als Leiterplatte mit integrierten elektrischen Leitungen und integrierten passiven elektrischen Bauteilen ausgebildet ist.

16. Trägeranordnung (40) zur Plasmabehandlung einer Mehrzahl von Substraten (14) in einer Behandlungskammer einer Plasmabehandlungsanlage, wobei die Trägeranordnung (40) mindestens zwei Elektrodeneinheiten (10a...10c) nach einem der Ansprüche 1 bis 15 enthält.

17. Trägeranordnung nach Anspruch 16, **dadurch gekennzeichnet, dass** mindestens ein internes elektrisches Zuführungsnetzwerk (17, 18, 20) einer Elektrodeneinheit (10a...10c) entlang einer Seite der Elektrodeneinheit (10a...10c) angeordnet ist, die nicht an eine andere Elektrodeneinheit (10a-10c) angrenzt.

18. Trägeranordnung nach Anspruch 16, **dadurch gekennzeichnet, dass** mindestens ein internes elektrisches Zuführungsnetzwerk (17, 18, 20) einer Elektrodeneinheit (10a...10) entlang einer Seite der Elektrodeneinheit (10a...10c) angeordnet ist, die an eine andere Elektrodeneinheit (10a...10c) angrenzt.

## Claims

1. Electrode unit (10, 101...109), suitable for plasma treatment of a plurality of substrates (14) in a treatment chamber of a plasma treatment system, comprising
- a plurality of plasma electrode pairs along a first direction, wherein each plasma electrode pair consists of a first plasma electrode (12) and a second plasma electrode (13) arranged parallel to each other and opposite each other and electrically insulated from each other, and is capable, in the presence of a defined voltage, of igniting a plasma in a plasma space (15) between the first and the second plasma electrode (12, 13) of the plasma electrode pair,
- at least one internal electrical supply network (17, 18, 20), which is suitable, within the treatment chamber, for supplying a first voltage to each first plasma electrode (12) of the electrode unit (10, 101...109) and a second voltage to each second plasma electrode (13) of the electrode unit (10, 101...109), wherein at least one of the voltages is a voltage having a frequency in the range of 1 MHz to 100 MHz,
- a first connection terminal (A) and a second connection terminal (B), which are suitable for feeding the first voltage through the first connection terminal (A) and the second voltage through the second connection terminal (B) into the at least one internal electrical supply network (17, 18, 20),
**characterised in that** the at least one internal electrical supply network (17, 18, 20) is designed according to the arrangement of the plasma electrodes (12, 13) within the electrode unit (10, 101... 109) and the frequency of the first voltage and/or the second voltage, wherein the at least one internal electrical supply network (17, 18, 20) has supply lines (174a-g, 184a-g) between the first and the second connection terminal (A, B) and at least two first and at least two second plasma electrodes (12, 13), respectively, and/or intermediate lines (172a-i, 182a-i, 212a-212i, 222a-222i) between two adjacent first or second plasma electrodes (2, 3) and one feed point (173, 182, 213, 222) into each of a first or second system (170, 180, 210, 220) of interconnected intermediate lines (172a-172i, 182a-182i, 212a-i, 222a-i), and one connecting line (171, 181, 211, 221) between each of the first and the second connection terminal (A, B) and the associated feed point (173, 183, 213, 223), and the design of the network consists of a suitable arrangement of the supply lines (174a-g, 184a-g) and/or suitable geometric dimensions of the suppy lines (174a-g, 184a-g) and/or of the intermediate lines (172a-i, 182a-i, 212a-212i, 222a-222i) and/or of the connecting lines (171, 181, 211, 221) and/or a suitable material of the supply lines (174a-g, 184a-g) and/or of the intermediate lines (172a-l, 182a-l, 212a-212i, 222a-222i) and/or of the connecting lines (171, 181, 211, 221) and/or a suitable arrangement of the feed point (173, 183, 213, 223) with respect to the electrode unit (10, 101...109) along the first direction.

2. Electrode unit according to claim 1, **characterised in that** the supply lines (174a-g, 184a-g) and/or the intermediate lines (172a-i, 182-i, 212-i, 222-i) and/or the connecting lines (171, 181, 211, 221) are each metal strips having a thickness in the range from 0.1 mm to 5 mm and a width in the range from 1 mm to 100 mmm.

3. Electrode unit according to either claim 1 or claim 2, **characterised in that** the supply lines (174a-g, 184a-g) and/or the intermediate lines (172a-i, 182-i, 212-i, 222-i) and/or the connecting lines (171, 181, 211, 221) each are metal strips of a highly conductive material from the group comprising aluminium, copper, silver, and silver-plated copper.

4. Electrode unit (101) according to any of the preceding claims, **characterised in that** the electrode unit has a first internal electrical supply network (17) that is suitable, within the treatment chamber, for supplying the first voltage to each first plasma electrode (12) of the electrode unit, and a second internal electrical supply network (18) that is suitable within the treatment chamber, for supplying the second voltage to each second plasma electrode (13) of the electrode unit, wherein the first supply network (17) and the second supply network (18) are spatially separated from each other, the feed point (173) of the first supply network (17) is arranged at the height of a first plasma electrode (12) arranged along the first direction as first in a group of first plasma electrodes (12) connected to each other by the first system (170) of intermediate lines (172a-i), and the feed point (183) of the second supply network (18) is arranged at the height of a second plasma electrode (13) arranged along the first direction as first in a group of second plasma electrodes (13) connected to each other by the second system (180) of intermediate lines (182a-i), so that the fed-in first or second voltage in the first and in the second system (170, 180) is forwarded in the same direction.

5. Electrode unit (102) according to any of claims 1 to 4, **characterised in that** the electrode unit has a first internal electrical supply network (17) that is suitable, within the treatment chamber, for supplying the first voltage to each first plasma electrode (12) of the electrode unit, and a second internal electrical supply network (18) that is suitable, within the treatment chamber, for supplying the second voltage to each second plasma electrode (13) of the electrode unit, wherein the first supply network (17) and the second supply network (18) are spatially separated from each other, the feed point (173) of the first supply network (17) is arranged at the height of a first plasma electrode (12) arranged along the first direction as first in a group of first plasma electrodes (12) connected to each other by the first system (170) of intermediate lines (172a-1), and the feed point (183) of the second supply network (18) is arranged at the height of a second plasma electrode (13) arranged along the first direction as last in a group of second plasma electrodes (13) connected to each other by the second system (180) of intermediate lines (182a-i), so that the fed-in first or second voltage in the first and in the second system (170, 180) is forwarded in the opposite direction.

6. Electrode unit (103) according to any of claims 1 to 4, **characterised in that** the electrode unit has a first internal electrical supply network (17) that is suitable, within the treatment chamber, for supplying the first voltage to each first plasma electrode (12) of the electrode unit, and a second internal electrical supply network (18) that is suitable, within the treatment chamber, for supplying the second voltage to each second plasma electrode (13) of the electrode unit, wherein the first supply network (17) and the second supply network (18) are spatially separated from each other, the feed point (173) of the first supply network (17) is arranged between a first plasma electrode (12) arranged along the first direction as first in a group of first plasma electrodes (12) connected to each other by the first system (170) of intermediate lines (172a-i), and another first plasma electrode (12) arranged along the first direction as last in the group of first plasma electrodes (12) connected to each other by the first system (170) of intermediate lines (172a-i), and the feed point (183) of the second supply network (18) is arranged between a second plasma electrode (13) arranged along the first direction as first in a group of second plasma electrodes (13) connected to each other by the second system (180) of intermediate lines (182a-i), and another second plasma electrode (13) arranged along the first direction as last in the group of second plasma electrodes (13) connected to each other by the second system (180) of intermediate lines (182a-i), so that the fed-in first or second voltage is forwarded in a first part (170a) of the first system (170) and in a first part (180a) of the second system (180) in the first direction and in a second part (170b) of the first system (170) and in a second part (180b) of the second system (180) in a second direction opposite to the first direction.

7. Electrode unit (104) according to claim 6, **characterised in that** the feed point (173) of the first supply network (17) is arranged along the first direction centrally in the first system (170) of interconnected intermediate lines (172a-i) and the feed point (183) of the second supply network (18) is arranged along the first direction centrally in the second system (180) of interconnected intermediate lines (182a-i), so that the fed-in first or second voltage is forwarded in a first half (170a) of the first system (170) and in a first half (180a) of the second system (170) in the first direction and in a second half (170b) of the first system (170) and in a second half (180b) of the second system (180) in a second direction that is opposite to the first direction.

8. Electrode unit (101...104) according to any of claims 1 to 7, **characterised in that** all first plasma electrodes (12) of the electrode unit are supplied with voltage by the first system (170) and all second plasma electrodes (13) are supplied with voltage by the second system (180).

9. Electrode unit (106) according to any of the claims 1 to 7, **characterised in that** the electrode unit has a first internal electrical supply network (17) that is suitable, within the treatment chamber, for supplying the first voltage to each first plasma electrode (12) of the electrode unit, and a second internal electrical supply network (18) that is suitable, within the treatment chamber, for supplying the second voltage to each second plasma electrode (13) of the electrode unit, wherein the first supply network (17) and the second supply network (18) are spatially separated from each other, each supply network (17, 18) has supply lines (174a, 174c-e, 184a, 184c-e) between the first and the second connection terminal (A, B) and at least two first and at least two second plasma electrodes (12, 13) and at least one supply line (174a, 174b, 184a, 184b) to at least one system (170, 180) of interconnected intermediate lines (172a, 172b, 182a, 182b), wherein the supply lines (174a-g, 184a-g), starting from a supply line (174a, 184a) that is connected to the first or second connection terminal (A, B), are divided in each case in binary fashion in a tree-shaped arrangement into two further supply lines (174b-e, 184b-e), until each of the at least two first or at least two second plasma electrodes (12, 13) and the at least one system (170, 180) of interconnected intermediate lines (172a, 172b, 182a, 182b) are contacted by a separate supply line (174b, 174d, 174e, 184b, 184d, 184e).

10. Electrode unit (105) according to any of claims 1 to 4, **characterised in that** the electrode unit has a first internal electrical supply network (17) that is suitable, within the treatment chamber, for supplying the first voltage to each first plasma electrode (12) of the electrode unit, and a second internal electrical supply network (18) that is suitable, within the treatment chamber, for supplying the second voltage to each second plasma electrode (13) of the electrode unit, wherein the first supply network (17) and the second supply network (18) are spatially separated from each other, each supply network (17, 18) has supply lines (174a-g, 184a-g) between the first and the second connection terminal (A, B) and each first and second plasma electrode (12, 13), respectively, wherein the supply lines (174a-g, 184a-g), starting from a supply line (174a, 184a) connected to the first or second connection terminal (A, B), are divided in each case in binary fashion in a tree-shaped arrangement into two further supply lines (174b-g, 184b-g), until each first and second plasma electrode (12, 13) is contacted through a separate supply line (174d-g, 184d-g).

11. Electrode unit (107) according to any of claims 1 to 4, **characterised in that** the electrode unit has only one internal electrical supply network (20), in which the first system (210) of interconnected intermediate lines (212a-i) that connects all first plasma electrodes (12) with each other, and the second system (220) of interconnected intermediate lines (222a-i) that connects all second plasma electrodes (13) with each other, are arranged spatially next to each other at a distance small enough that a capacitive and inductive coupling is present between the first system (210) and the second system (220) and is not negligible, and are separated from each other by an insulator, the first system (210) and the second system (220) are designed as a high-frequency line, the feed point (213) of the first system (210) is arranged at the height of a first plasma electrode (12) arranged along the first direction as first in a group of first plasma electrodes (12) connected to each other by the first system (210), and the feed point (223) of the second system (220) is arranged at the height of a second plasma electrode (13) arranged along the first direction as first in a group of second plasma electrodes (13) connected to each other by the second system (220), so that during a plasma treatment a resulting current flows in opposite directions in the first system (210) and in the second system (220).

12. Electrode unit (108) according to any of claims 1 to 4, **characterised in that** the electrode unit has only one internal electrical supply network (20), in which the first system (210) of interconnected intermediate lines (212a-i) that connects all first plasma electrodes (12) with each other, and a second system (220) of interconnected intermediate lines (222a-i) that connects all second plasma electrodes (13) with each other, are arranged spatially next to each other at a distance small enough that a capacitive and inductive coupling between the first system (210) and the second system (220) is present and is not negligible, and are separated from each other by an insulator, the first system (210) and the second system (220) are designed as a high-frequency line, the feed point (213) of the first system (210) is arranged at the height of a first plasma electrode (12) arranged along the first direction as first in a group of first plasma electrodes (12) connected to each other by the first system (210), and the feed point (223) of the second system (220) is arranged at the height of a second plasma electrode (13) arranged along the first direction as last in a group of second plasma electrodes (13) connected to each other by the second system (220), so that during a plasma treatment a resulting current flows in the same direction in the first system (210) and in the second system (220).

13. Electrode unit (109) according to any of the preceding claims, **characterised in that** at least one first or at least one second plasma electrode (12, 13) comprises a dielectric layer (30) arranged on a side facing a plasma space (15) belonging to one of these plasma electrodes (12, 13), and/or on a side facing a substrate (14) resting on this plasma electrode (12, 13).

14. Electrode unit according to any of the preceding claims, **characterised in that** the at least one internal electrical supply network (17, 18, 20) contains passive electrical components in addition to the supply lines (174a-g, 184a-g) and/or intermediate lines (172a-i, 182a-i, 212a-i, 222a-i) and/or connecting lines (171, 181, 211, 221).

15. Electrode unit according to any of the preceding claims, **characterised in that** the at least one internal electrical supply network (17, 18, 20) is designed as a printed circuit board with integrated electrical lines and integrated passive electrical components.

16. Carrier arrangement (40) for plasma treatment of a plurality of substrates (14) in a treatment chamber of a plasma treatment system, wherein the carrier arrangement (40) contains at least two electrode units (10a...10c) according to any of claims 1 to 15.

17. Carrier arrangement according to claim 16, **characterised in that** at least one internal electrical supply network (17, 18, 20) of one electrode unit (10a...10c) is arranged along a side of the electrode unit (10a...10c) that does not border another electrode unit (10a-10c).

18. Carrier arrangement according to claim 16, **characterised in that** at least one internal electrical supply network (17, 18, 20) of one electrode unit (10a...10) is arranged along a side of the electrode unit (10a...10c) that borders another electrode unit (10a-10c).

## Revendications

1. Unité d'électrode (10, 101...109) conçue pour le traitement au plasma d'une pluralité de substrats (14) dans une chambre de traitement d'un appareil de traitement au plasma, comportant
- une pluralité de paires d'électrodes à plasma suivant une première direction, chaque paire d'électrodes à plasma étant constituée d'une première électrode à plasma (12) et d'une seconde électrode à plasma (13) disposées parallèlement l'une à l'autre et opposées et isolées électriquement l'une de l'autre, et conçues pour allumer un plasma dans un espace plasma (15) entre les première et seconde électrodes à plasma (12, 13) de la paire d'électrodes à plasma en présence d'une tension définie,
- au moins un réseau d'alimentation électrique interne (17, 18, 20) conçu pour fournir, à l'intérieur de la chambre de traitement, une première tension de chaque première électrode à plasma (12) de l'unité d'électrode (10, 101...109) et une seconde tension de chaque seconde électrode à plasma (13) à l'unité d'électrode (10, 101...109), au moins l'une des tensions étant une tension ayant une fréquence comprise entre 1 et 100 MHz,
- une première borne de connexion (A) et une seconde borne de connexion (B) conçues pour fournir la première tension par l'intermédiaire de la première borne de connexion (A) et la seconde tension par l'intermédiaire de la seconde borne de connexion (B) dans l'au moins un réseau d'alimentation électrique interne (17, 18, 20),
**caractérisée en ce que** l'au moins un réseau d'alimentation électrique interne (17, 18, 20) est conçu selon la disposition des électrodes à plasma (12, 13) dans l'unité d'électrode (10, 101...109) et la fréquence de la première tension et/ou de la seconde tension, l'au moins un réseau d'alimentation électrique interne (17, 18, 20) présentant des lignes d'alimentation (174a-g, 184a-g) entre les première ou seconde bornes de connexion (A, B) et au moins deux premières ou au moins deux secondes électrodes à plasma (12, 13) et/ou lignes intermédiaires (172a-i, 182a-i, 212a-212i, 222a-222i) entre deux premières ou secondes électrodes à plasma adjacentes (2, 3) et respectivement un point d'alimentation (173, 183, 213, 223) dans un premier ou un second système (170, 180, 210, 220) comprenant des lignes intermédiaires (172a-172i, 182a-182i, 212a-i, 222ai) interconnectées et respectivement une ligne de connexion (171, 181, 211, 221) entre la première et la seconde borne de connexion (A, B) et le point d'alimentation associé (173, 183, 213, 223) et la conception du réseau dans une disposition appropriée des lignes d'alimentation (174a-g, 184a-g) et/ou dans des dimensions géométriques appropriées des lignes d'alimentation (174a-g, 184a-g) et/ou des lignes intermédiaires (172a-i, 182a-i, 212a-212i, 222a-222i) et/ou des lignes de connexion (171, 181, 211, 221) et/ou dans un matériau approprié des lignes d'alimentation (174a-g, 184a-g) et/ou des lignes intermédiaires (172a-i, 182a-i, 212a-i, 222a-i) et/ou des lignes de connexion (171, 181, 211, 221) et/ou dans une disposition appropriée du point d'alimentation (173, 183, 213, 223) par rapport à l'unité d'électrode (10, 101...109) suivant la première direction.

2. Unité d'électrode selon la revendication 1, **caractérisée en ce que** les lignes d'alimentation (174a-g, 184a-g) et/ou les lignes intermédiaires (172a-i, 182a-i, 212a-i, 222a-i) et/ou les lignes de connexion (171, 181, 211, 221) sont respectivement des bandes métalliques ayant une épaisseur comprise entre 0,1 et 5 mm et une largeur comprise entre 1 et 100 mm.

3. Unité d'électrode selon la revendication 1 ou 2, **caractérisée en ce que** les lignes d'alimentation (174a-g, 184a-g) et/ou les lignes intermédiaires (172a-i, 182a-i, 212a-i, 222a-i) et/ou les lignes de connexion (171, 181, 211, 221) sont respectivement des bandes métalliques constituées d'un matériau à haute conductivité choisi dans le groupe comprenant l'aluminium, le cuivre, l'argent de cuivre et le cuivre argenté.

4. Unité d'électrode (101) selon l'une des revendications précédentes, **caractérisée en ce que** l'unité d'électrode présente un premier réseau d'alimentation électrique interne (17) conçu pour fournir, à l'intérieur de la chambre de traitement, la première tension de chaque première électrode à plasma (12) à l'unité d'électrode, et un second réseau d'alimentation électrique interne (18) conçu pour fournir, à l'intérieur de la chambre de traitement, la seconde tension de chaque seconde électrode à plasma (13) à l'unité d'électrode, le premier réseau d'alimentation (17) et le second réseau d'alimentation (18) étant spatialement séparés, le point d'alimentation (173) du premier réseau d'alimentation (17) étant disposé au niveau d'une première électrode à plasma (12) disposée suivant la première direction comme première électrode dans un groupe de premières électrodes à plasma (12) interconnectées par le premier système (170) de lignes intermédiaires (172ai), et le point d'alimentation (183) du second réseau d'alimentation (18) étant disposé au niveau d'une seconde électrode à plasma (13) disposée suivant la première direction comme première électrode dans un groupe de secondes électrodes à plasma (13) interconnectées par le second système (180) de lignes intermédiaires (182a-i), de sorte que la première ou la seconde tension appliquée dans les premier et second systèmes (170, 180) est transmise dans la même direction.

5. Unité d'électrode (102) selon l'une des revendications 1 à 4, **caractérisée en ce que** l'unité d'électrode présente un premier réseau d'alimentation électrique interne (17) conçu pour fournir, à l'intérieur de la chambre de traitement, la première tension de chaque première électrode à plasma (12) à l'unité d'électrode, et un second réseau d'alimentation électrique interne (18) conçu pour fournir, à l'intérieur de la chambre de traitement, la seconde tension de chaque seconde électrode à plasma (13) à l'unité d'électrode, le premier réseau d'alimentation (17) et le second réseau d'alimentation (18) étant spatialement séparés, le point d'alimentation (173) du premier réseau d'alimentation (17) étant disposé au niveau d'une première électrode à plasma (12) disposée suivant la première direction comme première électrode dans un groupe de premières électrodes à plasma (12) interconnectées par le premier système (170) de lignes intermédiaires (172ai), et le point d'alimentation (183) du second réseau d'alimentation (18) étant disposé au niveau d'une seconde électrode à plasma (13) disposée suivant la première direction comme dernière électrode dans un groupe de secondes électrodes à plasma (13) interconnectées par le second système (180) de lignes intermédiaires (182a-i), de sorte que la première ou la seconde tension appliquée dans les premier et second systèmes (170, 180) transmise dans la direction opposée.

6. Unité d'électrode (103) selon l'une des revendications 1 à 4, **caractérisée en ce que** l'unité d'électrode présente un premier réseau d'alimentation électrique interne (17) conçu pour fournir, à l'intérieur de la chambre de traitement, la première tension de chaque première électrode à plasma (12) à l'unité d'électrode, et un second réseau d'alimentation électrique interne (18) conçu pour fournir, à l'intérieur de la chambre de traitement, la seconde tension de chaque seconde électrode à plasma (13) à l'unité d'électrode, le premier réseau d'alimentation (17) et le second réseau d'alimentation (18) étant spatialement séparés, le point d'alimentation (173) du premier réseau d'alimentation (17) étant disposé entre une première électrode à plasma (12) disposée suivant la première direction comme première électrode dans un groupe de premières électrodes à plasma (12) interconnectées par le premier système (170) de lignes intermédiaires (172a-i), et une autre première électrode à plasma (12) disposée suivant la première direction comme dernière électrode dans le groupe de premières électrodes à plasma (12) interconnectées par le premier système (170) de lignes intermédiaires (172a-i), et le point d'alimentation (183) du second réseau d'alimentation (18) se trouve entre une seconde électrode à plasma (13) disposée suivant la première direction comme première électrode dans un groupe de secondes électrodes à plasma (13) interconnectées par le second système (180) de lignes intermédiaires (182a-i), et une autre seconde électrode à plasma (13) disposée suivant la première direction comme dernière électrode dans le groupe de secondes électrodes à plasma (13) connectées par le second système (180) de lignes intermédiaires (182a-i), de sorte que la première ou la seconde tension fournie est transmise dans une première partie (170a) du premier système (170) et dans une première partie (180a) du second système (180) dans la première direction et dans une seconde partie (170b) du premier système (170) et dans une seconde partie (180b) du second système (180) dans une seconde direction opposée à la première direction.

7. Unité d'électrode (104) selon la revendication 6, **caractérisée en ce que** le point d'alimentation (173) du premier réseau d'alimentation (17) est disposé suivant la première direction au centre dans le premier système (170) de lignes intermédiaires interconnectées (172a-i) et le point d'alimentation (183) du second réseau d'alimentation (18) est disposé suivant la première direction au centre dans le second système (180) de lignes intermédiaires connectées (182a-i), de sorte que la première ou la seconde tension fournie est transmise dans une première moitié (170a) du premier système (170) et dans une première moitié (180a) du second système (170) dans la première direction et dans une seconde moitié (170b) du premier système (170) et dans une seconde moitié (180b) du second système (180) dans une seconde direction opposée à la première direction.

8. Unité d'électrode (101...104) selon l'une des revendications 1 à 7, **caractérisée en ce que** toutes les premières électrodes à plasma (12) de l'unité d'électrode sont alimentées en tension par le premier système (170) et toutes les secondes électrodes à plasma (13) sont alimentées en tension par le second système (180).

9. Unité d'électrode (106) selon l'une des revendications 1 à 7, **caractérisée en ce que** l'unité d'électrode présente un premier réseau d'alimentation électrique interne (17) conçu pour fournir, à l'intérieur de la chambre de traitement, la première tension de chaque première électrode à plasma (12) à l'unité d'électrode, et un second réseau d'alimentation électrique interne (18) conçu pour fournir, à l'intérieur de la chambre de traitement, la seconde tension de chaque seconde électrode à plasma (13) à l'unité d'électrode, le premier réseau d'alimentation (17) et le second réseau d'alimentation (18) étant spatialement séparés, chaque réseau d'alimentation (17, 18) présentant des lignes d'alimentation (174a, 174c-e, 184a, 184c-e) se trouvant entre les première ou seconde bornes de connexion (A, B) et au moins deux premières ou au moins deux secondes électrodes à plasma (12, 13) et au moins une ligne d'alimentation (174a, 174b, 184a, 184b) menant à au moins un système (170, 180) de lignes intermédiaires (172a, 172b, 182a, 182b) interconnectées, les lignes d'alimentation (174a-g, 184a-g), à partir d'une ligne d'alimentation (174a, 184a) connectée à la première ou à la seconde borne (A, B), se divisant de manière arborescente en deux autres lignes d'alimentation (174b-e, 184b-e), respectivement de manière binaire, jusqu'à ce que chacune des au moins deux premières ou au moins deux secondes d'électrodes plasma (12, 13) et l'au moins un système (170, 180) de lignes intermédiaires (172a, 172b, 182a, 182b) interconnectées soient en contact par l'intermédiaire d'une ligne d'alimentation séparée (174b, 174d, 174e, 184b, 184d, 184e).

10. Unité d'électrode (105) selon l'une des revendications 1 à 4, **caractérisée en ce que** l'unité d'électrode présente un premier réseau d'alimentation électrique interne (17) conçu pour fournir, à l'intérieur de la chambre de traitement, la première tension de chaque première électrode à plasma (12) à l'unité d'électrode, et un second réseau d'alimentation électrique interne (18) conçu pour fournir, à l'intérieur de la chambre de traitement, la seconde tension de chaque seconde électrode à plasma (13) à l'unité d'électrode, le premier réseau d'alimentation (17) et le second réseau d'alimentation (18) étant spatialement séparés, chaque réseau d'alimentation (17, 18) présentant des lignes d'alimentation (174a-g, 184a-g) se trouvant entre la première ou la seconde borne de connexion (A, B) et chaque première ou seconde électrode à plasma (12, 13), les lignes d'alimentation (174a-g, 184a-g), à partir d'une ligne d'alimentation (174a, 184a) connectée à la première ou à la seconde borne (A, B), se divisant de manière arborescente en deux autres lignes d'alimentation (174b-g, 184b-g), respectivement de manière binaire, jusqu'à ce que chaque première ou seconde électrode à plasma (12, 13) soit en contact par l'intermédiaire d'une ligne d'alimentation séparée (174d-g, 184d-g).

11. Unité d'électrode (107) selon l'une des revendications 1 à 4, **caractérisée en ce que** l'unité d'électrode présente uniquement un réseau d'alimentation électrique interne (20), dans lequel le premier système (210) de lignes intermédiaires (212a-i) interconnectées reliant toutes les premières électrodes à plasma (12), et le second système (220) de lignes intermédiaires interconnectées (222a-i) reliant toutes les secondes électrodes à plasma (13), de manière adjacente, à une distance si petite que des accouplements capacitif et inductif entre le premier système (210) et le second système (220) sont présents et non négligeables, disposés et séparés l'un de l'autre par un isolant, le premier système (210) et le second système (220) sont conçus comme une ligne à haute fréquence, le point d'alimentation (213) du premier système (210) se trouve au niveau d'une première électrode à plasma (12) disposée suivant la première direction comme première électrode dans un groupe de premières électrodes à plasma (12) interconnectées par le premier système (210), et le point d'alimentation (223) du second système (220) se trouve au niveau d'une seconde électrode à plasma (13), disposée suivant la première direction comme première électrode dans un groupe de secondes électrodes à plasma (13) interconnectées par le second système (220), de sorte que, pendant un traitement au plasma, un courant qui en résulte circule dans le premier système (210) et dans le second système (220) dans la direction opposée.

12. Unité d'électrode (108) selon l'une des revendications 1 à 4, **caractérisée en ce que** l'unité d'électrode présente uniquement un réseau d'alimentation électrique interne (20), dans lequel le premier système (210) de lignes intermédiaires (212a-i) interconnectées reliant toutes les premières électrodes à plasma (12) et un second système (220) de lignes intermédiaires interconnectées (222a-i) reliant toutes les secondes électrodes à plasma (13), de manière adjacente, à une distance si petite que des accouplements capacitif et inductif entre le premier système (210) et le second système (220) sont présents et non négligeables, disposés et séparés l'un de l'autre par un isolant, le premier système (210) et le second système (220) sont conçus comme une ligne à haute fréquence, le point d'alimentation (213) du premier système (210) se trouve au niveau d'une première électrode à plasma (12) disposée suivant la première direction comme première électrode dans un groupe de premières électrodes à plasma (12) interconnectées par le premier système (210), et le point d'alimentation (223) du second système (220) se trouve au niveau d'une seconde électrode à plasma (13), disposée suivant la première direction comme dernière électrode dans un groupe de secondes électrodes à plasma (13) interconnectées par le second système (220), de sorte que, pendant un traitement au plasma, un courant qui en résulte circule dans le premier système (210) et dans le second système (220) dans la même direction.

13. Unité d'électrode (109) selon l'une des revendications précédentes, **caractérisée en ce qu'**au moins une première ou au moins une seconde électrode à plasma (12, 13) se trouvant sur un côté orienté vers un espace à plasma (15) associé à cette électrode à plasma (12, 13) et/ou sur un côté orienté vers un substrat (14) reposant sur cette électrode à plasma (12, 13) présente une couche diélectrique (30).

14. Unité d'électrode selon l'une des revendications précédentes, **caractérisée en ce que** l'au moins un réseau d'alimentation électrique interne (17, 18, 20) comprend des composants électriques passifs en plus des lignes d'alimentation (174a-g, 184a-g) et/ou des lignes intermédiaires (172a-i, 182a-i, 212a-i, 222a-i) et/ou des lignes de connexion (171, 181, 211,221).

15. Unité d'électrode selon l'une des revendications précédentes, **caractérisée en ce que** l'au moins un réseau d'alimentation électrique interne (17, 18, 20) est réalisé comme une carte de circuit imprimé comportant des lignes électriques intégrées et des composants électriques passifs intégrés.

16. Ensemble de support (40) destiné au traitement au plasma d'une pluralité de substrats (14) dans une chambre de traitement d'un appareil de traitement au plasma, ledit ensemble de support (40) comprenant au moins deux unités d'électrode (10a...10c) selon l'une des revendications 1 à 15.

17. Ensemble de support selon la revendication 16, **caractérisé en ce qu'**au moins un réseau d'alimentation électrique interne (17, 18, 20) d'une unité d'électrode (10a...10c) est disposé le long d'un côté de l'unité d'électrode (10a...10c) non adjacent à une autre unité d'électrode (10a-10c).

18. Ensemble de support selon la revendication 16, **caractérisé en ce qu'**au moins un réseau d'alimentation électrique interne (17, 18, 20) d'une unité d'électrode (10a...10) est disposé le long d'un côté de l'unité d'électrode (10a...10c) adjacent à une autre unité d'électrode (10a...10c).
